# EUROPEAN PATENT SPECIFICATION

(11) **EP 3 366 808 B1**
(45) Date of publication and mention of the grant of the patent: **25.10.2023**
(21) Application number: 18158881.5
(22) Date of filing: 27.06.2014
(51) Int. Cl.: C23C 16/44, C23C 16/52, C23C 16/06, C07F 7/08, C23C 16/18, C23C 16/455

(54) **METHOD OF FORMING LAYERS ON A SUBSTRATE**
VERFAHREN ZUR SCHICHTBILDUNG AUF EINEM SUBSTRAT
PROCÉDÉ DE FORMATION DE COUCHES SUR UN SUBSTRAT

(30) Priority: 28.06.2013 US 201313930471; 10.11.2013 US 201361902264 P; 02.04.2014 US 201461974115 P
(43) Date of publication of application: 29.08.2018
(62) Divisional of application: 14817237.2
(73) Proprietor: Wayne State University, Detroit, MI 48202 (US)
(72) Inventor: WINTER, Charles, Bloomfield Hills, MI 48301 (US); KLESKO, Joseph Peter, Sterling Heights, MI 48310 (US)
(74) Representative: GPI & Associés

(56) References cited:
- US-A1- 2012 058 270
- MICHEL BORDEAU ET AL: "The electrochemical reductive trimethylsilylation of aryl chlorides: a good route to aryltrimethylsilanes and a novel route to tris(trimethylsilyl)cyclohexadienes", THE JOURNAL OF ORGANIC CHEMISTRY, vol. 57, no. 17, 1 August 1992 (1992-08-01), pages 4705-4711, XP055341734, ISSN: 0022-3263, DOI: 10.1021/jo00043a031
- H Bock ET AL: "Radical ions. 37. Ionization and one-electron oxidation of electron-rich silylalkyl olefins", Journal of the American Chemical Society, 1 June 1980 (1980-06-01), pages 4429-4438, XP55493301, DOI: 10.1021/ja00533a023 Retrieved from the Internet: URL:https://pubs.acs.org/doi/pdf/10.1021/j a00533a023
- WOLFGANG KAIM ET AL: "Electronic structure of 1,4-dihydro-1,2,4,5-tetrazines and of related 1,4-dihydroaromatic compounds", JOURNAL OF THE CHEMICAL SOCIETY, PERKIN TRANSACTIONS 2: PHYSICAL ORGANIC CHEMISTRY, no. 10, 1 January 1985 (1985-01-01), page 1633, XP55493411, GB ISSN: 0300-9580, DOI: 10.1039/p29850001633
- SUSANNE KRAFT ET AL: "Titanium-Based Molecular Squares and Rectangles: Syntheses by Self-Assembly Reactions of Titanocene Fragments and Aromatic N-Heterocycles", CHEMISTRY - A EUROPEAN JOURNAL, vol. 11, no. 3, 21 January 2005 (2005-01-21), pages 969-978, XP55493427, DE ISSN: 0947-6539, DOI: 10.1002/chem.200400880

## Description

This application is a divisional application to EP14817237.2 that was published under number EP3013997.

### STATEMENT REGARDING FEDERALLY SPONSORED RESEARCH OR

### DEVELOPMENT

The invention was made with Government support under Contract No. CHE-1212574 awarded by National Science Foundation. The Government has certain rights to the invention.

### FIELD OF THE INVENTION

In at least one aspect, the present invention is related to the formation of metal films from "metalorganic" precursors and a reducing agent.

### BACKGROUND OF THE INVENTION

The growth of thin films is a central step in the fabrication of many functional materials and devices. While film growth efforts have been traditionally directed toward films greater than 100 nm, recent trends in several areas are calling for the growth of films ranging in thickness from a few atomic layers to tens of nanometers.

In the microelectronics arena, copper has replaced aluminum as the interconnect material in integrated circuits due to its lower resistivity and higher resistance to electromigration. Ultrathin (2-8 nm) manganese-silicon-oxygen layers have been proposed as replacements for existing nitride-based copper diffusion barrier layers in future devices. Since copper does not nucleate well on SiO₂ and other surfaces, it is difficult to deposit copper metal onto the surface features of microelectronic substrates. Accordingly, there has been considerable interest in the formation of seed layers of metals such as chromium, cobalt, and others which adhere better to substrates, and upon which copper films can be subsequently grown.

Atomic layer deposition (ALD) is a thin film deposition technique that addresses many of the current technological demands. ALD affords inherently conformal coverage and sub-nanometer film thickness control due to its self-limited growth mechanism. In a typical ALD process, a substrate is contacted with a first chemical composition that modifies the substrate for a first predetermined period of time (a pulse). Such modification involves adsorption to the surface of the substrate, reaction with the surface of the substrate, or a combination of adsorption and reaction. A purging gas is introduced to remove any lingering first gaseous chemical composition in the vicinity of the substrate. A second gaseous chemical composition that reacts with the modified substrate surface is introduced for a second predetermined period of time into the vicinity of the substrate to form a portion of the thin film. A purging gas is subsequently introduced to remove any lingering second chemical composition in the vicinity of the substrate. These steps of contacting the substrate with the first chemical composition, purging, contacting the substrate with the second gaseous chemical composition, and purging are usually repeated a plurality of times until a film of desired thickness is coated onto the substrate. Although the prior art ALD processes work well, there is unfortunately only a limited number of chemical precursors having the requisite thermal stability, reactivity, and vapor pressure for ALD.

Accordingly, there is a need for improved methods and reagents for depositing thin films by atomic layer deposition.

The document US20120058270 A1 discloses compounds that can be used as precursors for the deposition of a thin film by atomic layer deposition and a corresponding process. These compounds have the formula MₓL_{y} wherein M is a transition metal, x is 1 or 2, y is an integer from 1 to 4, L is N(R₁R₂)-N=C(R₃)-O or OC(R₄)-N(R₅) ; R₁, R₂, R₃, R₄ and R₅ being each independently H, C₁-C₁₂ alkyl or C₆-C₁₂ aryl, Si(R₆) or Ge(R₆)₃ and R₆ is chosen among H, C₁-C₁₂ alkyl or C₆-C₁₂ aryl. According to this document, the process comprises contacting a substrate surface with the above-mentioned metal containing compound to form a first modified surface and contacting said modified surface with an activating compound. The activating compound may be a reducing agent.

The article XP055341734 entitled « the electrochemical reductive trimethylsilylation of aryl chlorides: a good route to aryltrimethylsilanes and a novel route to tris(trimethylsilyl)cyclohexadienes » published in The journal of organic chemistry, vol 57, N°17 on August, 1rst 1992 pages 4705-4711 and written by M. Bordeau et al discloses a new synthesis method of tris(trimethylsilyl) cyclohexadiene. It does not relate to thin layer deposition process.

The article XP055493301 entitled « Radical ions.37. ionization and one-electro oxidation of electron-rich silylalkyl olefins » published in the Journal of the American Chemical Society, on June, 1rst 1980 and written by H. Bock et al discloses compounds having the following formulas: 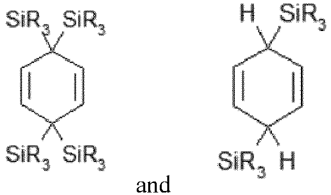 wherein R is a methyl group. It does relate to a thin layer deposition process.

The article XP055493411 entitled « Electronic structure of 1,4-dihydro-1,2,4,5-tetrazines and of related 1,4-dihydroaromatic compounds » published in Journal of the chemical society, Perkin transactions 2 : physical organic chemistry, n° 10 on January 1rst 1985, and written by W. Kain et al discloses the following compound : 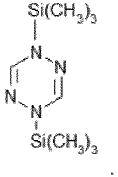 It does not relate to a thin layer deposition process.

The article XP055493427 entitled « Titanium-based molecular squares and rectangles: syntheses by self-assembly reactions of titanocene fragments and aromatic N-heterocycles », published in Chemistry- A European Journal, vol 11, N) 3 on January 21rst 2005 pages 969-978 and written by S. Kraft et al discloses a compound having the following formula: 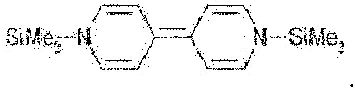 It clearly does not relate to a thin layer deposition process.

### SUMMARY OF THE INVENTION

The present invention as claimed solves one or more problems of the prior art by providing a method of forming a layer on a substrate, the method comprising a deposition cycle including:
a) contacting a substrate with a vapor of a first compound to form a first modified surface, the first compound having an atom in an oxidized state to form said first modified surface, said atom being selected from the group consisting of Cu, Ni, Cr, Mn, Fe, Co;
b) contacting the first modified surface with an acid for a second predetermined pulse time to form a second modified surface; and
c) contacting the second modified surface with a reducing agent for a third predetermined pulse time to reduce the atom to a zero oxidation state and to form a layer on the substrate, the reducing agent being 1,4-bis(trimethylsilyl)-1,4-dihydropyrazine.

According to one embodiment, the atom is in a positive oxidation state of 1, 2, 3, 4, 5, or 6.

The first compound can be selected from bis(dimethylamino-2-propoxy) copper (II) (Cu(dmap)2), bis(dimethylamino-2-propoxy) nickel (II) (Ni(dmap)2, bis(1,4-di-tert-butyldiazene) chromium(II) (Cr(dadtBu2)2), bis(1,4-di-tert-butyldiazene) manganese (II) (Mn(dadtBu2)2), bis(1,4-di-tert-butyldiazene) iron(II) (Fe(dadtBu2)2), bis(1,4-di-tert-butyldiazene) cobalt(II) (Co(dadtBu2)2) and bis(1,4-di-tert-butyldiazene) nickel(II) (Ni(dadtBu2)2).

According to another embodiment, the substrate is additionally contacted with the vapor of the first compound having an atom in an oxidized state, the acid, and the vapor of a reducing agent during a plurality of additional deposition cycles.

The substrate can be selected from SiH and Co when said first compound is Cu(dmap)2, Si when said first compound is Ni(Dmap)2, Ru when said first compound is Ni(Dmap)2 or Ni(dadtBu2)2, Pd when said first compound is Ni(Dmap)2, Cu when said first compound is Ni(dadtBu2)2, Ru or SiO2 when said first compound is Cr(dadtBu2)2, Ru or SiO2 when said first compound is Mn(dadtBu2)2, SiO2 when said first compound is Fe(dadtBu2)2, Ru or SiO2 when said first compound is Co(dadtBu2)2.

The acid can be formic acid.

### BRIEF DESCRIPTION OF THE DRAWINGS

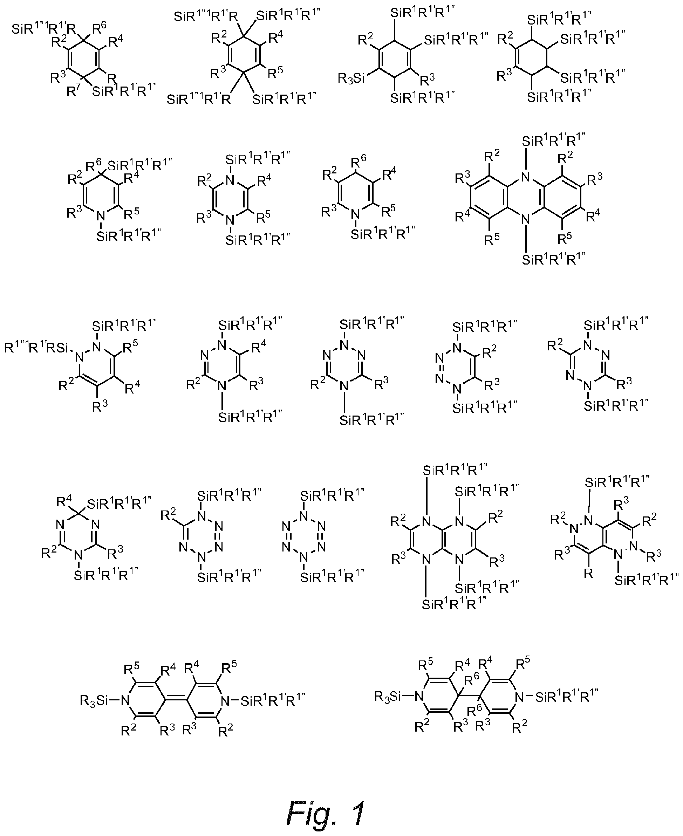

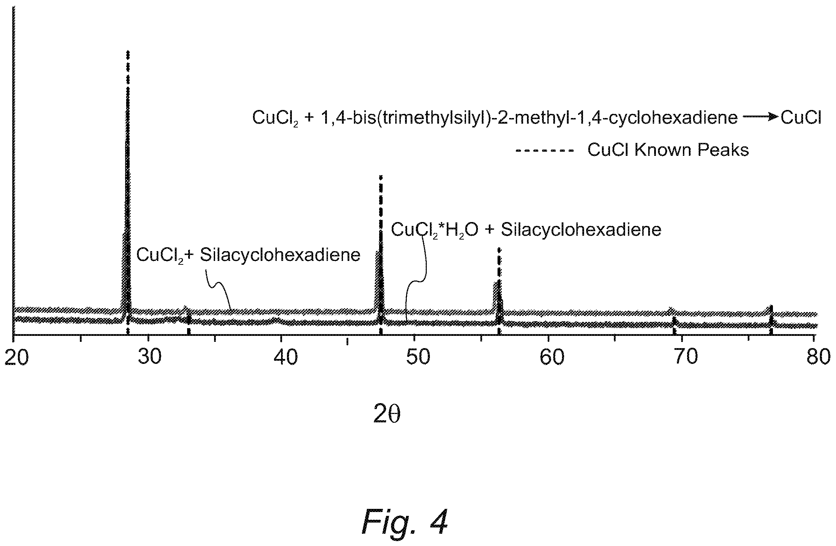

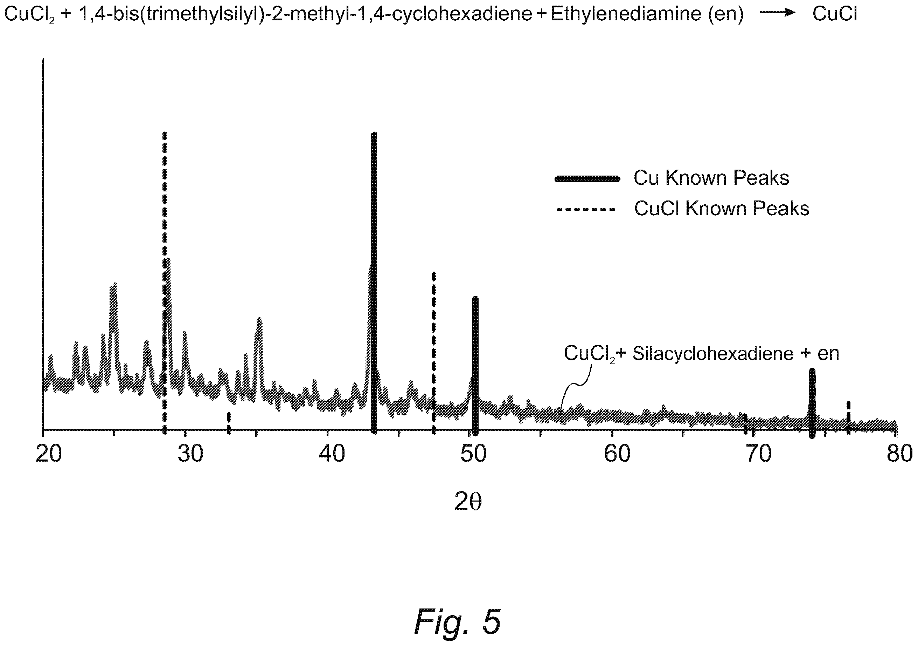

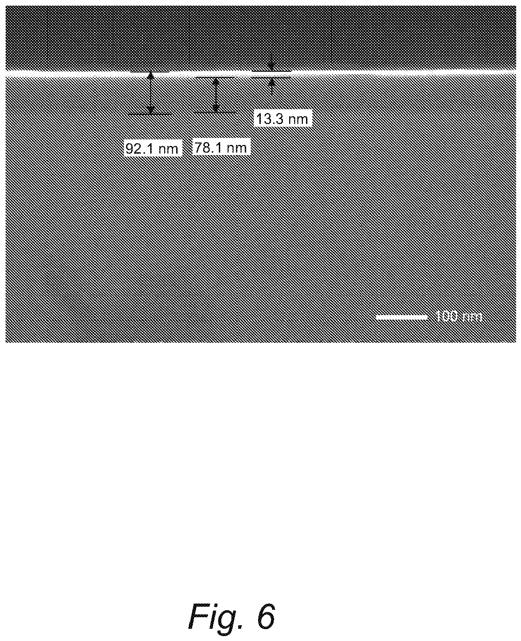

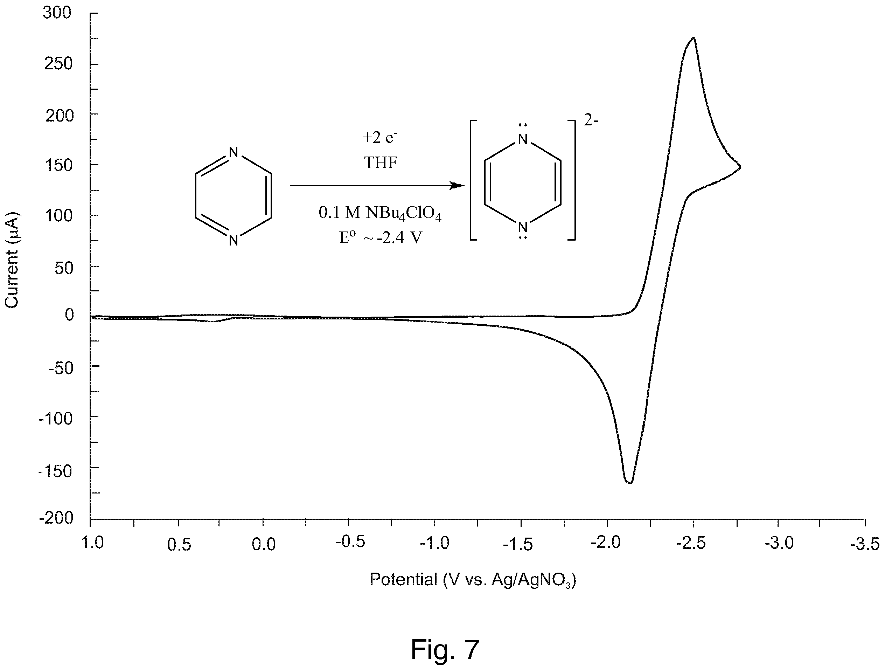

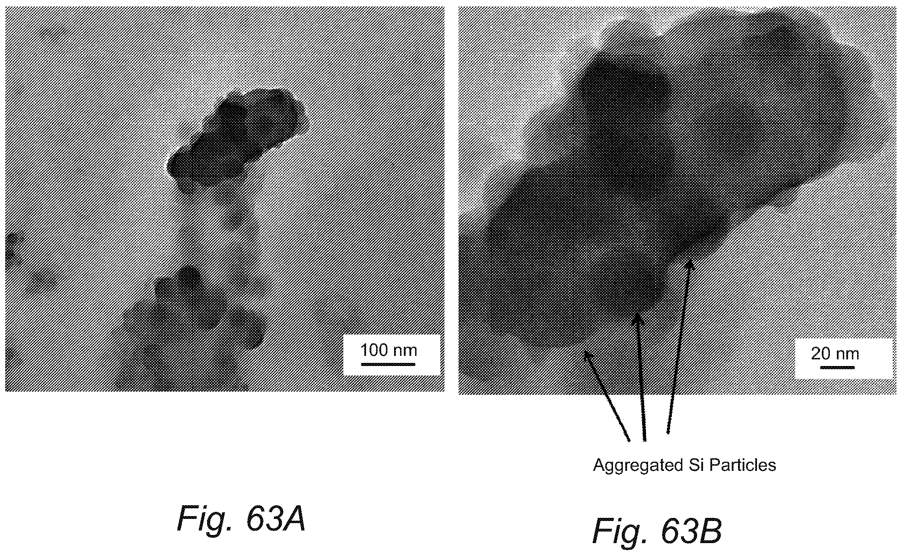

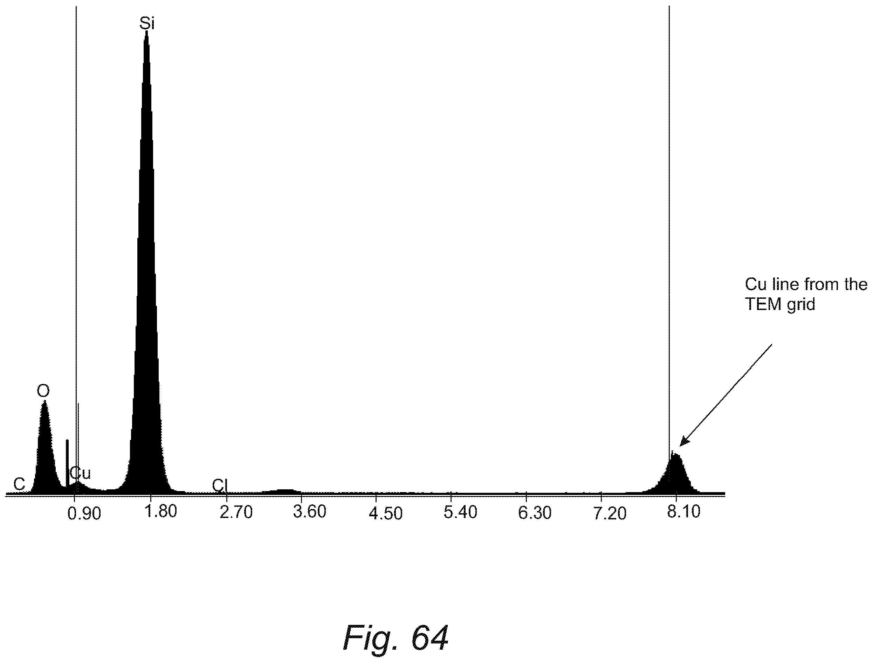

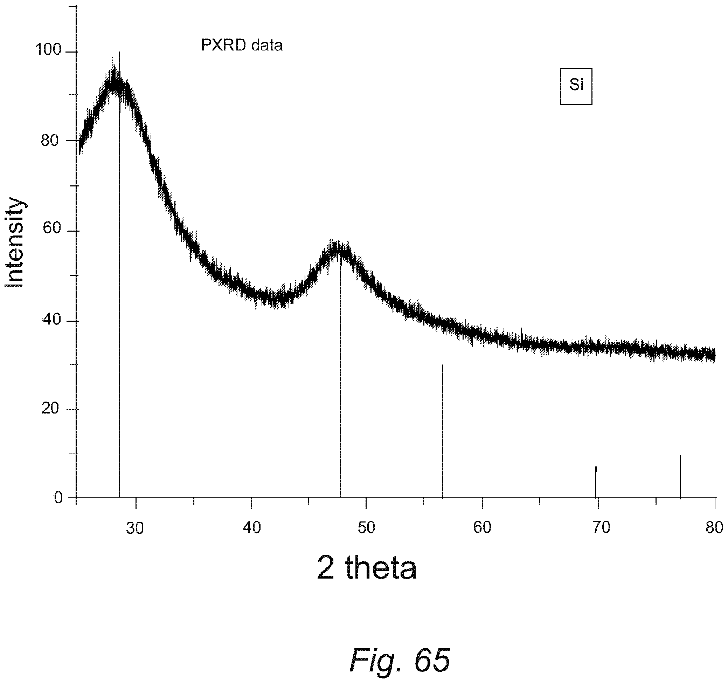

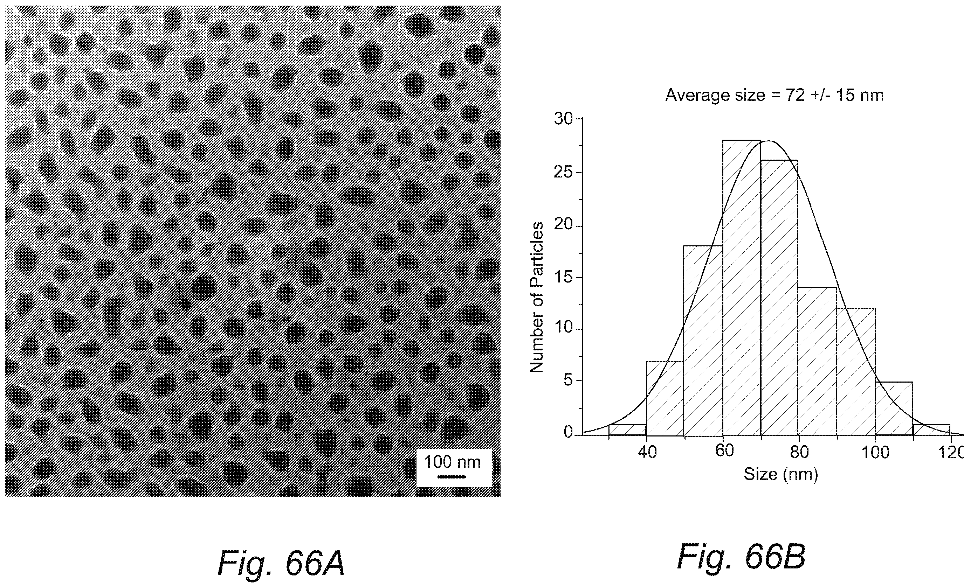

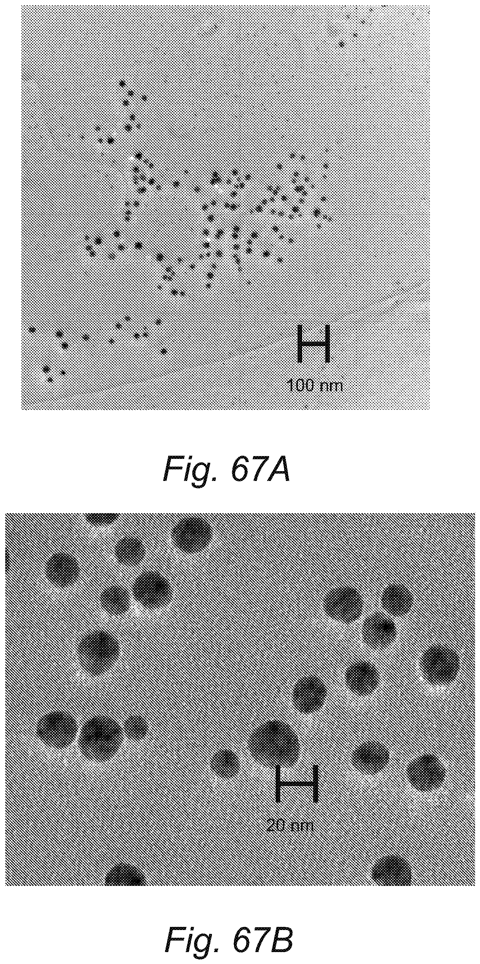

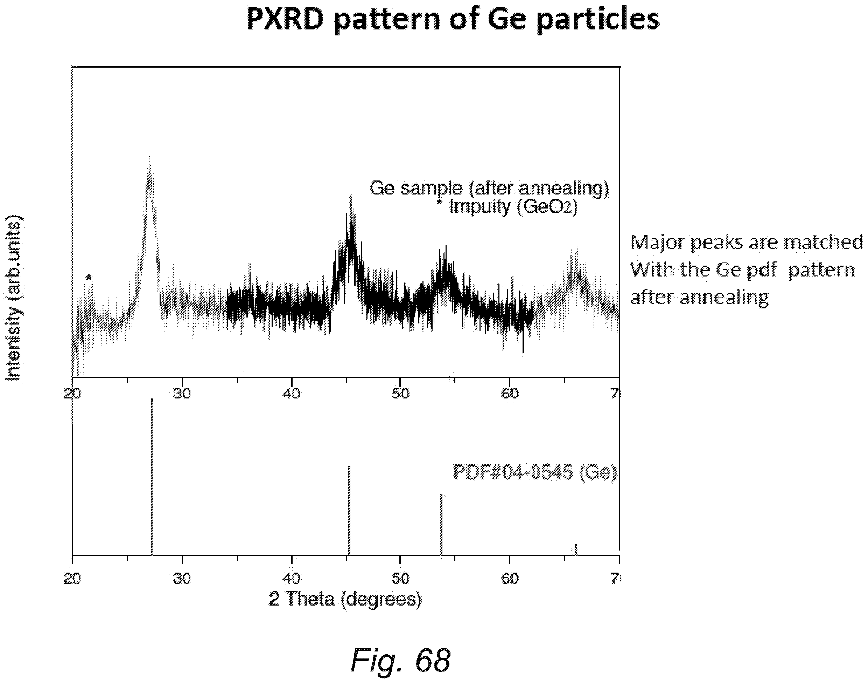

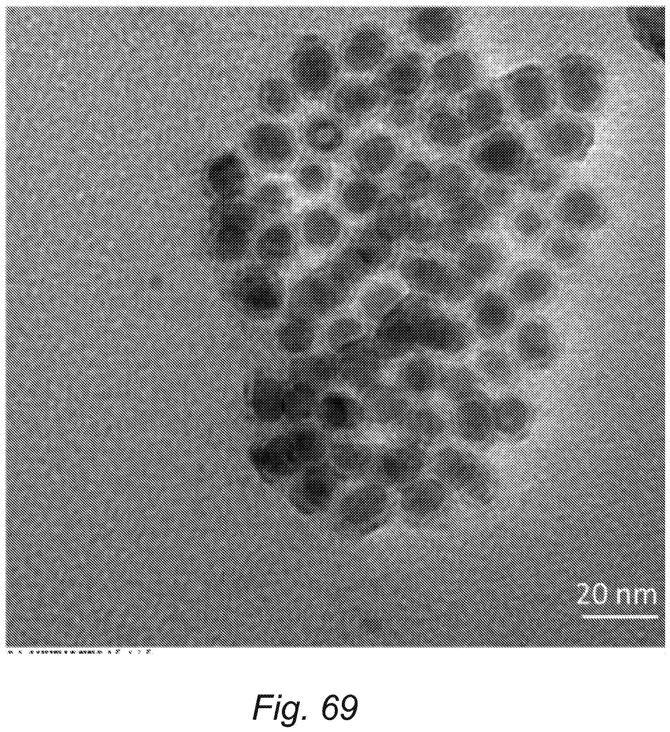

The following figures are not according to the invention and are present for illustration purpose only: Fig. 1, 3, 4, 5, 6, 7, 38 to 56 and 63 to 69.

Exemplary embodiments of the present invention will become more fully understood from the detailed description and the accompanying drawings, wherein:
FIGURE 1 provides additional examples of reducing agents;
FIGURE 2A is a schematic flowchart illustrating an ALD deposition process using the bis(trimethylsilyl) six-membered ring systems of an embodiment of the invention;
FIGURE 2B is a schematic flowchart illustrating an ALD deposition process using the bis(trimethylsilyl) six-membered ring systems of an embodiment of the invention;
FIGURE 2C is a schematic flowchart illustrating an ALD deposition process using the bis(trimethylsilyl) six-membered ring systems of an embodiment of the invention;
FIGURE 2D is a schematic illustration of an ALD deposition system used in an embodiment of the present invention;
FIGURE 2E is a schematic cross-section of a vapor source containing the reducing agents;
FIGURE 3 provides examples of acids that can be reacted with the compounds of formula I;
FIGURE 4 provides X-ray diffraction spectra showing CuCl formed by the solution reductions of CuCl₂ and CuCl₂•H₂O by 1,4-bis(trimethylsilyl)-2-methyl-1,4-cyclohexadiene;
FIGURE 5 provides an X-ray diffraction spectrum showing copper metal formed by the solution reduction of CuCl₂ to CuCl by 1,4-bis(trimethylsilyl)-2-methyl-1,4-cyclohexadiene , and the subsequent disproportionation to copper metal by ethylenediamine;
FIGURE 6 provides a scanning electron micrograph of a copper film (~ 8 nm) on a ruthenium-coated (5 nm) SiO₂ wafer;
FIGURE 7 provides a cyclic voltammogram of pyrazine referenced to Ag/AgNO₃;
FIGURE 8 provides an X-ray diffraction spectrum showing copper metal formed by the solution reduction of Cu(tmhd)₂ by 1,4-bis(trimethylsilyl)-1,4-dihydropyrazine;
FIGURE 9 provides a cross-sectional SEM micrograph of a copper film on a SiH substrate formed from Cu(dmap)₂;
FIGURE 10 provides a top-down SEM micrograph of a copper film on Co/SiO₂ formed from Cu(dmap)₂;
FIGURE 11 provides XPS survey scans of a 51 nm copper film deposited on SiH at 150 °C formed from Cu(dmap)₂;
FIGURE 12 provides an XPS high-resolution multiplex of the Cu 2p3 region of a film formed from Cu(dmap)₂;
FIGURE 13 provides a cross-sectional SEM micrograph of a nickel film on a Si(100) substrate formed from Ni(dmap)₂;
FIGURE 14 provides a cross-sectional SEM micrograph of a nickel film on a Ru/SiO₂ substrate formed from Ni(dmap)₂;
FIGURE 15 provides XPS survey scans of a 32 nm nickel film deposited on Pd at 150 °C formed from Ni(dmap)₂;
FIGURE 16 provides an XPS high-resolution multiplex of the Ni 2p3 region of a film formed from Ni(dmap)₂;
FIGURE 17 provides a cross-sectional SEM micrograph of a chromium film on a Ru/SiO₂ substrate formed from Cr(dad^{tBu2})₂;
FIGURE 18 provides a cross-sectional SEM micrograph of chromium film on a SiO₂ substrate formed from Cr(dad^{tBu2})₂;
FIGURE 19 provides XPS survey scnas of a 124 nm thick chromium film deposited on thermal SiO₂ at 225° C formed from Cr(dad^{tBu2})₂;
FIGURE 20 provides an XPS high-resolution multiplex of the Cr 2p3 region of a film formed from Cr(dad^{tBu2})₂;
FIGURE 21 provides a cross-sectional SEM micrograph of a manganese film on a Ru/SiO₂ substrate formed from Mn(dad^{tBu2})₂;
FIGURE 22 provides a top-down SEM micrograph of a manganese film on a Ru/SiO₂ substrate formed from Mn(dad^{tBu2})₂;
FIGURE 23 provides XPS survey scans of a 27 nm manganese film deposited on SiO₂ at 225 °C formed from Mn(dad^{tBu2})₂;
FIGURE 24 provides an XPS high-resolution multiplex of the Mn 2p3 region of a film formed from Mn(dad^{tBu2})₂;
FIGURE 25 provides a cross-sectional SEM micrograph of an iron film on a thermal SiO₂ substrate formed from Fe(dad^{tBu2})₂;
FIGURE 26 provides a top-down SEM micrograph of an iron film on thermal SiO₂ formed from Fe(dad^{tBu2})₂;
FIGURE 27 provides XPS survey scans of a 35 nm thick iron film deposited on Ru/SiO₂ at 225 °C formed from Fe(dad^{tBu2})₂;
FIGURE 28 provides an XPS high-resolution multiplex of the Fe 2p3 region of a film formed from Fe(dad^{tBu2})₂;
FIGURE 29 provides a cross-sectional SEM micrograph of a cobalt film on a Ru/SiO₂ substrate formed from Co(dad^{tBu2})₂;
FIGURE 30 provides a top-down SEM micrograph of a cobalt film on a thermal SiO₂ substrate formed from Co(dad^{tBu2})₂;
FIGURE 31 provides XPS survey scans of a 24 nm thick cobalt film deposited on Ru/SiO₂ at 180 °C from Co(dad^{tBu2})₂;
FIGURE 32 provides an XPS high-resolution multiplex of the Co 2p3 region of a film formed from Co(dad^{tBu2})₂;
FIGURE 33 provides an X-ray diffraction spectrum of showing cobalt metal on a SiO₂ substrate formed from Co(dad^{tBu2})₂;
FIGURE 34 provides a cross-sectional SEM micrograph of a nickel film on a Ru/SiO₂ substrate formed from Ni(dad^{tBu2})₂;
FIGURE 35 provides a top-down SEM micrograph of a nickel film on a copper substrate formed from Ni(dad^{tBu2})₂;
FIGURE 36: provides XPS survey scans of a 34 nm thick nickel film deposited on Ru/SiO₂ at 180 °C from Ni(dad^{tBu2})₂;
FIGURE 37: provides an XPS high-resolution multiplex of the Ni 2p3 region for a film formed from Ni(dad^{tBu2})₂;
FIGURE 38 provides X-ray diffraction (XRD) spectra for solution reaction precipitates formed from the reaction with titanium tetrachloride and CHD (e.g., formula IA) and titanium tetrachloride and DHP (e.g., formula IB);
FIGURE 39A provides an SEM cross-section for an ALD film deposited on a platinum substrate from the reaction with titanium tetrachloride and CHD at 180° C;
FIGURE 39B provides an SEM cross-section for an ALD film deposited on a silicon substrate with a thermal silicon oxide layer from the reaction with titanium tetrachloride and CHD at 180° C;
FIGURE 39C provides an SEM cross-section for an ALD film deposited on a palladium substrate from the reaction with titanium tetrachloride and CHD at 180° C
FIGURE 39D provides an SEM cross-section for an ALD film deposited on a cobalt substrate from the reaction with titanium tetrachloride and CHD at 180° C;
FIGURE 40 provides XPS survey scans for an ALD film deposited on a platinum substrate from the reaction with titanium tetrachloride and CHD at 180° C;
FIGURE 41 provides XPS multiplex scans for an ALD film deposited on a platinum substrate from the reaction with titanium tetrachloride and CHD at 180° C;
FIGURE 42 provides XPS survey scans for ALD film deposited on a silicon substrate with a thermal silicon oxide layer from the reaction with titanium tetrachloride and CHD at 180° C;
FIGURE 43 provides XPS multiplex scans for an ALD film deposited on silicon substrate with a thermal silicon oxide layer from the reaction with titanium tetrachloride and CHD at 180° C;
FIGURE 44A provides an SEM cross-section for an ALD film deposited on a platinum substrate from the reaction with titanium tetrachloride and DHP;
FIGURE 44B provides an SEM cross-section for an ALD film on a silicon substrate with a thermal silicon oxide layer from the reaction with titanium tetrachloride and DHP;
FIGURE 44C provides an SEM cross-section for an ALD film on a palladium substrate from the reaction with titanium tetrachloride and DHP;
FIGURE 44D provides an SEM cross-section for an ALD film on a cobalt substrate from the reaction with titanium tetrachloride and DHP;
FIGURE 45 provides X-ray diffraction (XRD) spectra for ALD films formed from the reaction with titanium tetrachloride and DHP on a platinum substrate and a silicon oxide substrate;
FIGURE 46 provides Energy-dispersive X-ray (EDS) spectra for ALD films formed from the reaction with titanium tetrachloride and DHP on a platinum substrate and a silicon oxide substrates;
FIGURE 47 provides XPS survey scans for an ALD film deposited on a platinum substrate from the reaction with titanium tetrachloride and DHP at 100° C;
FIGURE 48 provides XPS multiplex scans for an ALD film deposited on a platinum substrate from the reaction with titanium tetrachloride and DHP at 100° C;
FIGURE 49 provides XPS survey scans for an ALD film deposited a silicon substrate with a thermal silicon oxide layer from the reaction with titanium tetrachloride and DHP at 100° C;
FIGURE 50 provides XPS multiplex scans for an ALD film deposited on a silicon substrate with a thermal silicon oxide layer from the reaction with titanium tetrachloride and DHP at 100° C;
FIGURE 51A provides a SEM cross-section of an aluminum film deposited on a silicon substrate with a thermal silicon oxide layer from trimethylaluminum and DHP at 180° C;
FIGURE 51B provides a SEM cross-section of an aluminum film deposited on a cobalt-coated silicon substrate from trimethylaluminum and DHP at 180° C;
FIGURE 52 provides XPS survey scans for an ALD film deposited on a cobalt-coated silicon substrate from trimethylaluminum and DHP at 180° C;
FIGURE 53 provides XPS multiplex scans for an ALD film deposited on a cobalt-coated silicon substrate from trimethylaluminum and DHP at 180° C;
FIGURE 54A provides an SEM cross-section for an ALD film deposited on a platinum substrate from antimony trichloride and DHP at 180° C;
FIGURE 54B provides an SEM top-down view for an ALD film deposited on a platinum substrate from antimony trichloride and DHP at 180° C;
FIGURE 54C provides an SEM cross-section for an ALD film deposited on a palladium substrate from antimony trichloride and DHP at 180° C;
FIGURE 54D provides an SEM top-down view for an ALD film deposited on a palladium substrate from antimony trichloride and DHP at 180° C;
FIGURE 55 provides XPS survey scans for an ALD film deposited on a palladium substrate from antimony trichloride and DHP at 180° C;
FIGURE 56 provides XPS multiplex scans for an ALD film deposited on a palladium substrate from antimony trichloride and DHP at 180° C;
FIGURE 57 provides sheet resistances for cobalt films grown on Ru, Pt, and Pd substrates;
FIGURE 58 provides growth rates and sheet resistances versus temperature for cobalt films on a Ru substrate;
FIGURE 59 provides SEM cross-sectional micrographs of cobalt films on Ru substrates;
FIGURE 60 provides SEM cross-sectional micrographs of cobalt films on Ru substrates;
FIGURE 61 provides SEM top-down view micrographs of cobalt films on Ru substrates;
FIGURE 62 provides SEM top-down view micrographs of cobalt films on Ru substrates;
FIGURE 63 provides TEM images of methanol-washed un-capped Si particles;
FIGURE 64 provides an EDS analysis of methanol-washed Si particles;
FIGURE 65 provides a PXRD spectrum of Si particles;
FIGURE 66 provides a TEM image and size distribution of Si particles;
FIGURE 67 provides TEM images of Si particles in which methanol was added before reaction with 1-octanol;
FIGURE 68 provides the PXRD spectrum of the formed Ge particles; and
FIGURE 69 provides a TEM image of the Ge nanoparticles. Since the samples were handled outside after isolation, it is believed that the lighter area around the nanoparticles may be due to the surface oxidation.

### DESCRIPTION OF THE INVENTION

Reference will now be made in detail to presently preferred compositions, embodiments, and methods of the present invention which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

Except in the examples, or where otherwise expressly indicated, all numerical quantities in this description indicating amounts of material or conditions of reaction and/or use are to be understood as modified by the word "about" in describing the broadest scope of the invention. Practice within the numerical limits stated is generally preferred. Also, unless expressly stated to the contrary: percent, "parts of," and ratio values are by weight; "R" groups include H, C₁₋₁₀ alkyl, C₂₋₁₀ alkenyl, C₆₋₁₄ aryl (e.g., phenyl, halo, or C₄₋₁₄ heteroaryl; the description of a group or class of materials as suitable or preferred for a given purpose in connection with the invention implies that mixtures of any two or more of the members of the group or class are equally suitable or preferred; description of constituents in chemical terms refers to the constituents at the time of addition to any combination specified in the description, and does not necessarily preclude chemical interactions among the constituents of a mixture once mixed; the first definition of an acronym or other abbreviation applies to all subsequent uses herein of the same abbreviation and applies *mutatis mutandis* to normal grammatical variations of the initially defined abbreviation; and, unless expressly stated to the contrary, measurement of a property is determined by the same technique as previously or later referenced for the same property.

It must also be noted that, as used in the specification and the appended claims, the singular form "a," "an," and "the" comprise plural referents unless the context clearly indicates otherwise. For example, reference to a component in the singular is intended to comprise a plurality of components.

### Abbreviations

"ALD" is atomic layer deposition.
"CVD is chemical vapor deposition.
"RT" means "room temperature."
"s" means "seconds."
"THF" means "tetrahydrofuran."
"DME" means "1,2-dimethoxyethane."
"CHD" means 1,4-bis(trimethylsilyl)-2-methyl-1,4-cyclohexadiene.
"DHP" means 1,4-bis(trimethylsilyl)-1,4-dihydropyrazine.
"dad" means diazadiene.
"dad^{tBu2}" means "1,4-di-tert-butyldiazadiene."
"XPS" means "X-ray photoelectron spectroscopy."
"SEM" means "scanning electron microscopy."
"XRD" means "X-ray diffraction."
"acac" is acetylacetonate.
"Cp" is cyclopentadienyl.
"dmap" is 1-dimethylamino-2-methyl-2-propoxy.
"en" is ethylene diamine.
"Et" is ethyl.
"EtCp" is ethylcyclopentadienyl.
"Et₂amd" is N, N'-diethylacetamidinate.
"Et₂fmd" is N,N'-diethylformamidinate.
"hfac" is 1,1,1,5,5,5-hexafluoro-acetylacetonate.
"iPr₂amd" is N, N'-diisopropylacetamidinate.
"iPr₂fmd" is N,N'-diisopropylformamidinate.
"iPrCp" is isopropylcyclopentadienyl.
"Me" is methyl.
"Me₂amd" is N, N'-dimethylacetamidinate.
"Me₂fmd" is N,N'-dimethylformamidinate.
"Mes" is 2,4,6-Me₃C₆H₂ or mesityl.
"MeCp" is methylcyclopentadienyl.
"Me₅Cp" is pentamethylcyclopentadienyl.
"Me₂fmd" is N,N'-dimethylformamidinate.
"Me₂bmd" is N-N'-dimethylbutyramidinate.
"Me₂pmd" is N, N'-dimethylpropionamidinate.
"mmp" is 1-methoxy-2-methyl-2-propoxy.
"OtPe" is tert-pentoxy.
"od" is octane-2 4-dionate.
"OiPr" is isopropoxy.
"OtBu" is tert-butoxy.
"OEt" is ethoxy.
"tBu₂amd" is N, N'-di-tert-butylacetamidinate.
"tBuEtamd" is N-tert-butyl-N'-ethylacetamidinate.
"tBuEtpmd" is N-tert-butyl-N'-ethyl-propionamidinate.
"tBuEtbmd" is N-tert-butyl-N'-ethylbutyramidinate.
"thd" is 2,2,6,6-tetramethyl- heptane-3,5-dionate.
"TEM" is transmission electron microscopy.
"PXRD" is powder X-ray diffraction.
"EDS" is Energy-dispersive X-ray spectroscopy.

The term "standard electrode potential" means the electrical potential (i.e., the voltage developed) of a reversible electrode at standard state in which solutes are at an effective concentration of 1 mol/liter, the activity for each pure solid, pure liquid, or for water (solvent) is 1, the pressure of each gaseous reagent is 1 atm., and the temperature is 25 °C. Standard electrode potentials are reduction potentials.

In a further refinement, a method of forming a metal film by an ALD process is provided.
The method comprises a deposition cycle which includes contacting the substrate with vapor of a first compound having an atom in an oxidized state as set forth above such that at least a portion of the vapor of the first compound adsorbs or reacts with a substrate surface to form a modified surface.
The deposition cycle further includes contacting the modified surface with a vapor of the reducing agents set forth above to react and form at least a portion of the metal film.
Typically, the first compound having an atom in an oxidized state is contacted with the reducing agent at a temperature from about 50 to 400 ° C.
The present reaction is used in an ALD process as set forth below.

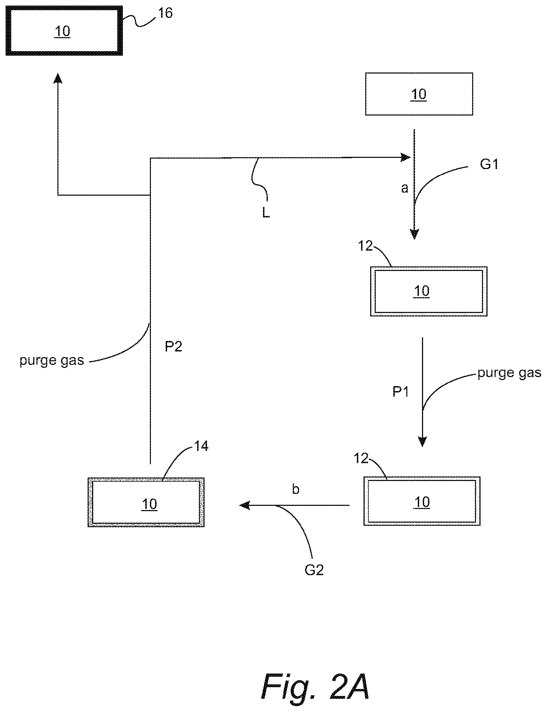

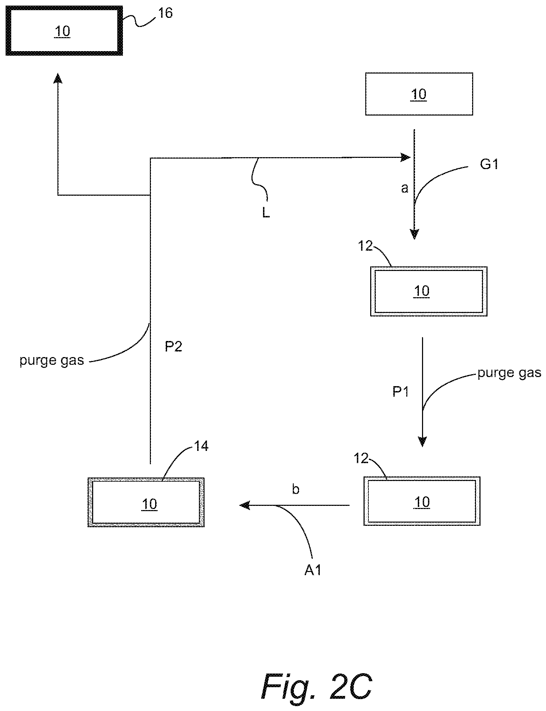

With reference to Figure 2A, a method for forming a layer by an ALD process is schematically illustrated. In step a), substrate 10 is contacted with a vapor G1 of a first compound having an atom in an oxidized state to form a first modified surface 12. The atom in an oxidized state is selected from the group consisting Groups 2-12 of the Periodic Table, the lanthanides, As, Sb, Bi, Te, Si, Ge, Sn, and Al. In particular, the first compound is as set forth above. In step b) the first modified surface 12 is contacted with a reducing agent G2 for a predetermined pulse time to form layer 14 on the substrate 10. The details of the reducing agent are as set forth above. Purging steps P1 and P2 are performed after steps a) and b), respectively. Loop L indicates that steps a), P1), b), and P2) are repeated a plurality of times in order to build up a final layer 16 of predetermined thickness monolayer by monolayer. Additional details of this ALD process are set forth below.

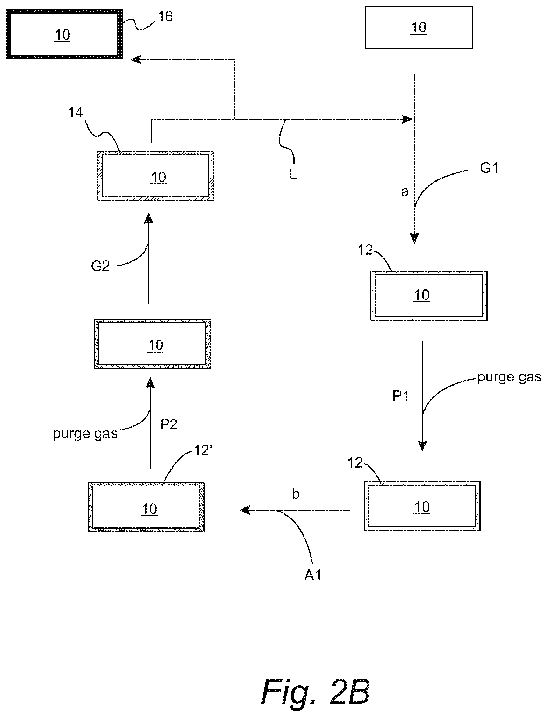

With reference to Figure 2B, a method for forming a layer by an ALD process is schematically illustrated. In step a), substrate 10 is contacted with a vapor G1 of a first compound having an atom in an oxidized state to form a first modified surface 12. The atom in an oxidized state is selected from the group consisting of Groups 2-12 of the Periodic Table, the lanthanides, As, Sb, Bi, Te, Si, Ge, Sn, and Al In particular, the first compound is as set forth above. In step b), the first modified surface 12 is contacted with an acid A1 for a second predetermined pulse time to form a second modified surface 12'. In step c), the second modified surface 12' is contacted with a reducing agent G2 for a third predetermined pulse time to form layer 14 on the substrate. Purging steps P1, P2, and P3 are performed after steps a), b), and c), respectively. Loop L indicates that steps a), P1), b), P2), c), and P3 are repeated a plurality of times in order to build up a final layer 16 of predetermined thickness monolayer by monolayer. The details of the reducing agent are as set forth above. Additional details of this ALD process are set forth below.

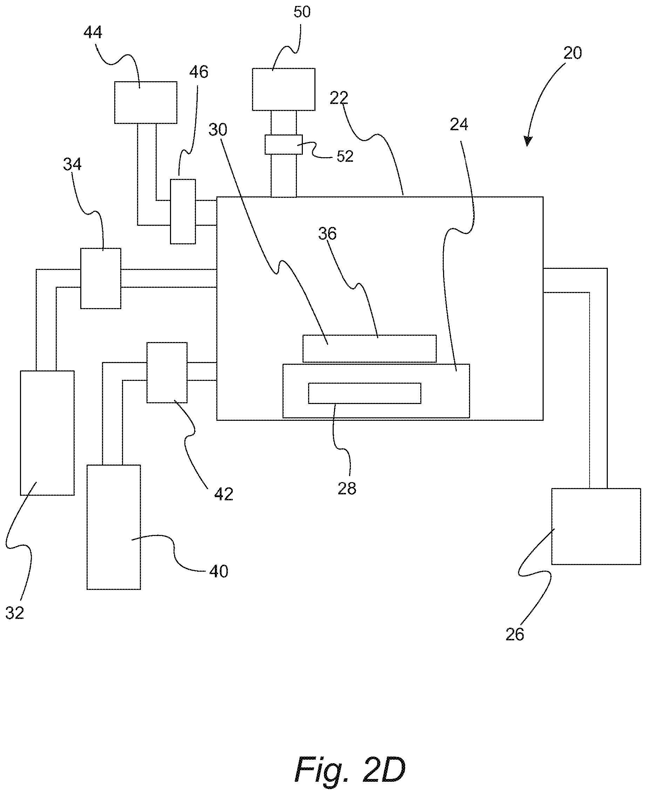

With reference to Figure 2D, deposition system 20 includes reaction chamber 22, substrate holder 24, and vacuum pump 26. Typically, the substrate is heated via heater 28. The method has a deposition cycle comprising contacting substrate 30 with a vapor of the first compound having an atom in an oxidized state as set forth above. In particular, the vapor is introduced from precursor source 32 into reaction chamber 22 for a predetermined pulse time. The pulse time is controlled via control valve 34. At least a portion of the vapor of the first compound modifies (e.g, adsorbs or reacts with) substrate surface 36 to form a modified surface. The method further comprises contacting the modified surface with a vapor of the reducing agent as set forth above from source 40 for a predetermined pulse time controlled by valve 42.

In a variation of the present embodiment, the method further comprises removing at least a portion of the vapor of the first compound that is lingering in the gas phase (i.e., has not adsorbed or reacted with the substrate) from the vicinity of the substrate before introducing the vapor of the reducing agent and removing at least a portion of the vapor of the reducing agent from the vicinity of the substrate. The metal-containing compound and the reducing agent are removed in purging steps by introducing a purge gas from purge source 44 into reaction chamber 22 for a predetermined purge time. The purge time is controlled by control valve 46.

In another variation, the method further includes at least one additional deposition cycle comprising sequentially contacting the substrate with the vapor of the first compound and then the vapor of the reducing agent. In some refinements, the substrate is contacted for a plurality of additional deposition cycles. For example, the substrate may be contacted with from 1 to several thousand deposition cycles depending on the thickness of the film desired. In particular, the substrate is contacted with the vapor of the first compound having an atom in an oxidized state and then the vapor of the reducing agent for 1 to 5000 deposition cycles. In another refinement, the substrate is contacted with the vapor of the first compound having an atom in an oxidized state and then the vapor of the reducing agent for 10 to 2000 deposition cycles. In still another refinement, the substrate is contacted with the vapor of the first compound having an atom in an oxidized state and then the vapor of the reducing agent for 20 to 1000 deposition cycles.

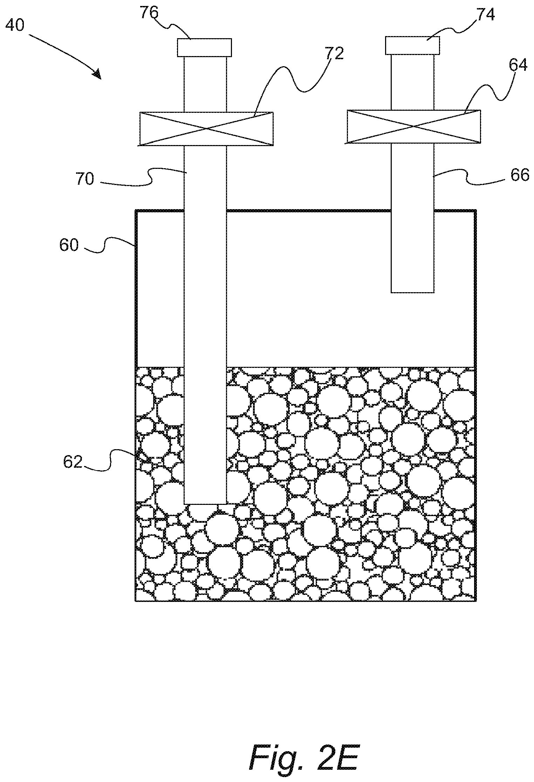

The system of Figure 2D uses a source 40 for providing the vapor of a reducing agent. Figure 2E provides a schematic cross-section of such a vapor source. Reducing agent source 40 includes vessel 60 and reducing agent 62 which is contained within and held by the vessel. Reducing agent 62 is one or more of the reducing agents set forth above. In particular, reducing agent 62 is described by IA, IB, IIA, IIB, IIC, and IID. In a refinement, at least a portion of the reducing agent is in the liquid phase. Valve 64 is attached to vessel 60. Valve 64 prevents escape of the reducing agent when the valve is closed and allows escape (i.e., passage into the ALD reaction chamber 22 through output conduit 66) of the reducing agent when the valve is opened. In a refinement, source 40 is a bubbler having an input conduit 70 for flowing a gas into vessel 60 and out of output conduit 66 thereby transferring the reducing agent. Valve 72 allows input conduit 70 to be opened and closed. In a refinement, in a refinement reducing agent source 40 includes fitting 74 positioned outside of and in fluid communication with valve 64. Optional, fitting 76 is position outside of and in fluid communication with valve 72. Fittings 74 and 76 allow attachment of the reducing agent source to ALD or CVD equipment.

In another embodiment, a system and method of forming a metal-containing film is provided. With reference to Figure 2D, the vapor of the first compound having an atom in an oxidized state is introduced from precursor source 32 into reaction chamber 22 for a first predetermined pulse time. The first predetermined pulse time should be sufficiently long that available binding sites on the substrate surface (coated with metal layers or uncoated) are saturated (i.e., metal-containing compound attached). Typically, the first predetermined pulse time is from 1 second to 20 seconds. The first predetermined pulse time is controlled via control valve 34. At least a portion of the vapor of the metal-containing compound modifies (e.g, adsorbs or reacts with) substrate surface 36 to form a first modified surface. Reaction chamber 22 is then purged with an inert gas from purge source 44 for a first purge time. The first purge time is sufficient to remove the metal-containing compound from reaction chamber 22 and is typically from 0.5 seconds to 2 minutes.

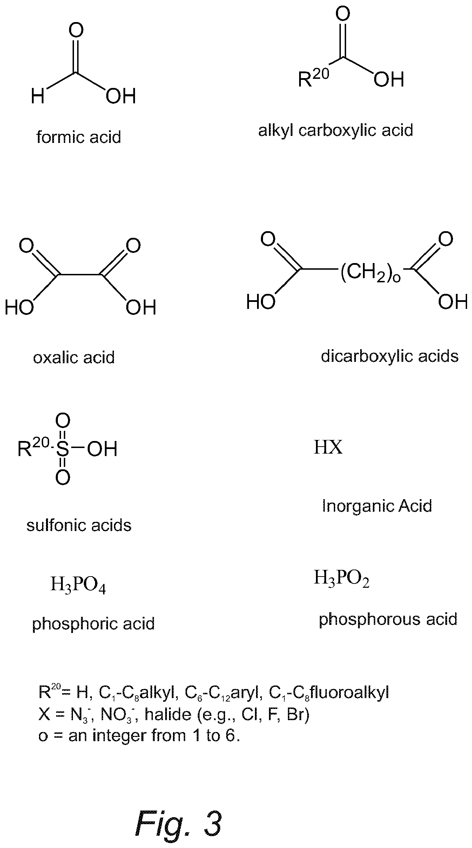

In the next reaction step of the deposition cycle, an acid such as formic acid is then introduced from acid source 50 into reaction chamber 22 for a second predetermined pulse time. Examples of other suitable acids are provided in Figure 3. In Figure 3, R²⁰ is H (i.e., hydride), C₁₋₈ alkyl, C₆₋₁₂ aryl, or C₁₋₈ fluoroalkyl, X is N₃⁻, NO₃⁻, halide (e.g., Cl, F, Br), and o is an integer from 1 to 6. In a refinement, R²⁰ is hydride, C₁₋₄ alkyl, C₆₋₁₀ aryl, or C₁₋₄ fluoroalkyl, X is N₃⁻, NO₃⁻, halide (e.g., Cl, F, Br), and n is an integer from 1 to 6. Examples of useful alkyl groups include, but are not limited to, methyl, ethyl, n-propyl, isopropyl, n-butyl, t-butyl, isobutyl, sec-butyl, and the like. Examples of useful aryl groups include, but are not limited to, phenyl, tolyl, naphthyl, and the like. The second predetermined pulse time is controlled via valve 52 and should be sufficiently long that available binding sites on the first modified substrate surface are saturated and a second modified surface is formed. Typically, the second predetermined pulse time is from 0.1 second to 20 seconds. Reaction chamber 22 is then purged with an inert gas for a second purge time (typically, 0.5 seconds to 2 minutes as set forth above).

In the final reaction step of the deposition cycle, a reducing agent as set forth above is then introduced from reducing agent source 40 into reaction chamber 22 for a third predetermined time controlled by valve 42. The third predetermined pulse time should be sufficiently long that available binding sites on the second modified substrate surface are saturated, with a metal layer being formed thereon. Typically, the third predetermined pulse time is from 0.1 second to 20 seconds. Reaction chamber 22 is then purged with an inert gas for a third purge time (typically, 0.5 second to 2 minutes as set forth above).

During film formation by the method of the present embodiment, the substrate will be at a temperature suitable to the properties of the chemical precursor(s) and film to be formed. In a refinement of the method, the substrate is set to a temperature from about 0 to 1000 °C. In another refinement of the method, the substrate has a temperature from about 50 to 450 °C. In another refinement of the method, the substrate has a temperature from about 100 to 250 °C. In still another refinement of the method, the substrate has a temperature from about 150 to 400 °C. In another refinement of the method, the substrate has a temperature from about 200 to 300 °C.

Similarly, the pressure during film formation is set at a value suitable to the properties of the chemical precursors and film to be formed. In one refinement, the pressure is from about 10⁻⁶ Torr to about 760 Torr. In another refinement, the pressure is from about 0.1 millitorr to about 10 Torr. In still another refinement, the pressure is from about 1 to about 100 millitorr. In yet another refinement, the pressure is from about 1 to 20 millitorr.

Pulse times and purge times also depend on the properties of the chemical precursors and the geometric shape of the substrates. Thin film growth on flat substrates uses short pulse and purge times, but pulse and purge times in ALD growth on 3-dimensional substrates can be very long. Therefore, in one refinement, pulse times and purge times are each independently from about 0.0001 to 200 seconds. In another refinement, pulse and purge times are each independently from about 0.1 to about 10 seconds.

With reference to Figure 2B, another variation for forming a metal film is schematically illustrated. In step a), substrate 10 is contacted with a vapor of a metal-containing compound G1 having formula III or IV to form a first modified surface 12 on the substrate 10. In step b), the first modified surface 12 is then contacted with a vapor of the activating compound A1 to form a second modified surface 12'. In step c), the second modified surface 12' is then contacted with the vapor of a reducing agent G2 to form at least a portion of a metal film on the substrate. Examples of suitable reducing agents include, but are not limited to, hydrazine, hydrazine hydrate, alkyl hydrazines, 1,1-dialkylhydrazines, 1,2-dialkylhydrazines, H₂, H₂ plasma, ammonia, ammonia plasma, silanes, disilanes, trisilanes, germanes, diborane, formalin, amine borane, dialkyl zinc, alkyl aluminum, alkyl gallium, alkyl indium complexes, and other plasma-based gases, and combinations thereof. Additional examples of reducing agents include the bis(trimethylsilyl) six-membered ring systems and related compounds as set forth above.

With reference to Figure 2D, deposition system 20 includes reaction chamber 22, substrate holder 24, and vacuum pump 26. Typically, the substrate is heated via heater 28. The method has a deposition cycle comprising contacting substrate 30 with a vapor of the compound having formula III or IV or the variations of these compounds as set forth above. In particular, the vapor is introduced from precursor source 32 into reaction chamber 22 for a predetermined pulse time. The pulse time is controlled via control valve 34. At least a portion of the vapor of the compound having formula III or IV modifies (e.g, adsorbs or reacts with) substrate surface 36 to form a modified surface. The method further comprises contacting the modified surface with a vapor of the activating compound (e.g., C₁₋₅ organic acids such as formic acid and C₁₋₈ diketone) as set forth above from source 50 for a predetermined pulse time to form a metal layer or metal-containing layer.

In a variation of the present embodiment, the method further comprises removing at least a portion of the vapor of the compound having formula III or IV that is lingering in the gas phase (i.e., has not adsorbed or reacted with the substrate) from the vicinity of the substrate before introducing the vapor of the activating compound and removing at least a portion of the vapor of the activating compound from the vicinity of the substrate. The metal-containing compound and the activating compound are removed in purging steps by introducing a purge gas from purge source 44 into reaction chamber 22 for a predetermined purge time. The purge time is controlled by control valve 46.

In another variation, the method further includes at least one additional deposition cycle comprising sequentially contacting the substrate with the vapor of the compound having formula III or IV and then the vapor of the reducing agent. In some refinements, the substrate is contacted for a plurality of additional deposition cycles. For example, the substrate may be contacted with from 1 to several thousand deposition cycles depending on the thickness of the film desired. In particular, the substrate is contacted with the vapor of the compound having formula III or IV and then the vapor of the activating compound for 1 to 5000 deposition cycles. In another refinement, the substrate is contacted with the vapor of the compound having formula III or IV and then the vapor of the activating compound for 10 to 2000 deposition cycles. In still another refinement, the substrate is contacted with the vapor of the compound having formula III or IV and then the vapor of the activating compound for 20 to 1000 deposition cycles.

In another embodiment, a method of forming a metal-containing film is provided. With reference to Figure 2D, the vapor of the compound having formula III or IV is introduced from precursor source 32 into reaction chamber 22 for a first predetermined pulse time. The first predetermined pulse time should be sufficiently long that available binding sites on the substrate surface (coated with metal layers or uncoated) are saturated (i.e., metal-containing compound attached). Typically, the first predetermined pulse time is from 1 second to 20 seconds. The first predetermined pulse time is controlled via control valve 34. At least a portion of the vapor of the metal-containing compound modifies (e.g, adsorbs or reacts with) substrate surface 36 to form a first modified surface. Reaction chamber 22 is then purged with an inert gas from purge gas source 44 for a first purge time. The first purge time is sufficient to remove the metal-containing compound from reaction chamber 22 and is typically from 0.5 seconds to 2 minutes.

In the next reaction step of the deposition cycle, the activating compound (e.g., C₁₋₅ organic acids such as formic acid and C₁₋₈ diketone) as set forth above is then introduced from source 50 into reaction chamber 22 for a second predetermined pulse time. The second predetermined pulse time is controlled via valve 52 and should be sufficiently long that available binding sites on the first modified substrate surface are saturated and a second modified surface is formed. Typically, the second predetermined pulse time is from 0.1 second to 20 seconds. The second predetermined pulse time is controlled via control valve 32. Reaction chamber 12 is then purged with an inert gas for a second purge time (typically, 0.5 seconds to 2 minutes as set forth above).

In the final reaction step of the deposition cycle, a reducing agent having formula IA or IB or the derivatives thereof as set forth above is then introduced from reducing agent source 40 into reaction chamber 22 for a third predetermined time controlled by valve 42. The third predetermined pulse time should be sufficiently long that available binding sites on the second modified substrate surface are saturated, with a metal layer being formed thereon. Typically, the third predetermined pulse time is from 0.1 second to 20 seconds. Reaction chamber 22 is then purged with an inert gas for a third purge time (typically, 0.5 seconds to 2 minutes as set forth above).

In a variation of the present embodiment, the method further includes at least one additional deposition cycle comprising sequentially contacting the substrate with the vapor of the compound having formula III or IV and then the vapor of the reducing agent. In some refinements, the substrate is contacted for a plurality of additional deposition cycles. For example, the substrate may be contacted with from 1 to several thousand deposition cycles depending on the thickness of the film desired. In particular, the substrate is contacted with the vapor of the compound having formula III or IV and then the vapor of the activating compound for 1 to 5000 deposition cycles. In another refinement, the substrate is contacted with the vapor of the compound having formula III or IV and then the vapor of the activating compound for 10 to 2000 deposition cycles. In still another refinement, the substrate is contacted with the vapor of the compound having formula III or IV and then the vapor of the activating compound for 20 to 1000 deposition cycles.

During film formation by the methods set forth above, the substrate will be at a temperature suitable to the properties of the chemical precursor(s) and film to be formed. In a refinement of the method, the substrate is set to a temperature from about 0 to 1000 °C. In another refinement of the method, the substrate has a temperature from about 50 to 450 °C. In another refinement of the method, the substrate has a temperature from about 100 to 250 °C. In still another refinement of the method, the substrate has a temperature from about 150 to 400 °C. In another refinement of the method, the substrate has a temperature from about 200 to 300 °C.

Similarly, the pressure during film formation is set at a value suitable to the properties of the chemical precursors and film to be formed. In one refinement, the pressure is from about 10⁻⁶ Torr to about 760 Torr. In another refinement, the pressure is from about 0.1 millitorr to about 10 Torr. In still another refinement, the pressure is from about 1 to about 100 millitorr. In yet another refinement, the pressure is from about 1 to 20 millitorr.

Pulse times and purge times also depend on the properties of the chemical precursors and the geometric shape of the substrates. Thin film growth on flat substrates uses short pulse and purge times, but pulse and purge times in ALD growth on 3-dimensional substrates can be very long. Therefore, in one refinement, pulse times and purge times are each independently from about 0.0001 to 200 seconds. In another refinement, pulse and purge times are each independently from about 0.1 to about 10 seconds.

### Experimental Section

All experiments employed the use of anhydrous reagents and solvents, obtained from Sigma Aldrich. Syntheses of CHD and DHP were carried out using Schlenk line techniques, following previously referenced literature procedures contained in U.S. Pat. Appl. No. 13930471 filed June 28, 2013. Solution reactions and sample preparations for deposition experiments were conducted in an argon dry box. A Picosun R-75BE ALD reactor was used for thin film depositions. The reactor was operated under a constant stream of nitrogen (99.9995%) at a pressure of 10-12 mbar. Film thicknesses were determined using cross-sectional field emission scanning electron microscopy (FESEM) on a JEOL-6510LV electron microscope. Powder and thin film XRD experiments were performed on a Rigaku R200B 12kW rotating anode diffractometer, using Cu K_{α} radiation (1.54056 Å) at 40 kV and 150 mA. XPS analysis was performed on a Perkin-Elmer 5500 XPS system using monochromatized Al K_{α} radiation. AugerScan v3.2 was used as the analysis software. Deposited thin films were exposed to air for several days prior to XPS analysis.

### 1,4-bis(trimethylsilyl)-1,4-dihydropyrazine

1,4-bis(trimethylsilyl)-1,4-dihydropyrazine was prepared on a 40 g scale following a literature procedure (Sulzbach, R. A.; Iqbal, A. F. M. Angew. Chem. Int. Ed. Engl. 1971, 10, 127). The air-sensitive, yellow solid was purified by sublimation at 80 °C /0.05 Torr. Preparative sublimation of the product yielded 97.1 % recovery with no residue. The thermal decomposition temperature was determined to be greater than 265 °C.

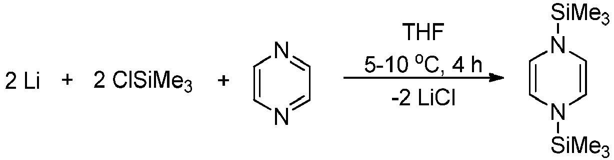

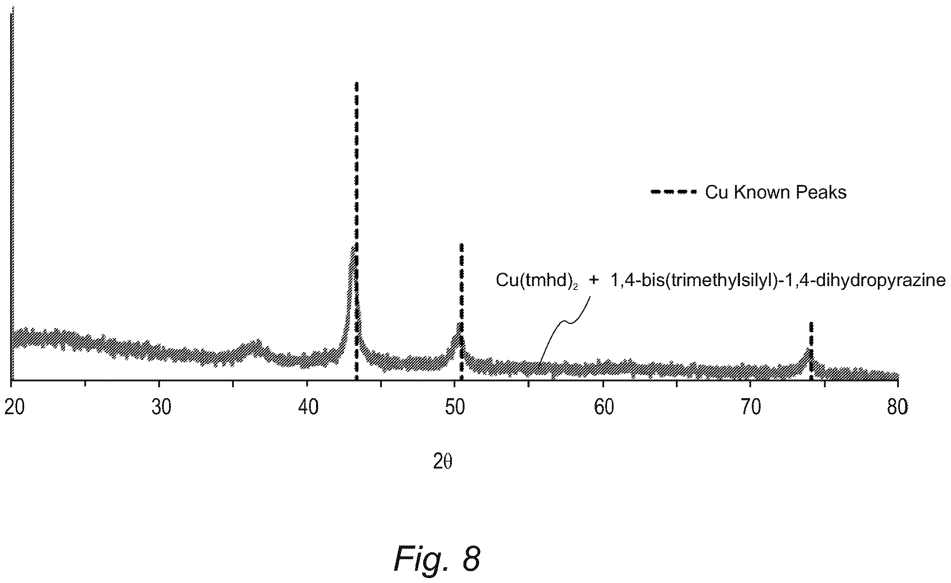

Solution reactions were conducted with a variety of metal salts in THF. Upon refluxing with DHP, precipitate formation was observed from Cu, Ni, Co, Fe, Zn, and Cr salts (Table 3). Copper precipitate was observed as regions of copper-colored film on the flask and metallic flakes in solution, while cobalt and iron precipitated out as the ferromagnetic metals, sticking to the stir bar. The precipitate resulting from the reaction of copper bis(2,2,6,6-tetramethyl-3,5-heptanedionate) [Cu(tmhd)₂] with DHP was identified as copper metal by XRD (Figure 8).

**Table 3: Reaction matrix of metal salts with DHP**

| ML₂ | THF | Reaction | | Reflux | | Reaction solution → Precipitate |
|---|---|---|---|---|---|---|
| | | Temp | Time (min) | Temp | Time (min) | |
| Cu(dmap)₂ | 50 ml | RT | 15 | 65 °C | 60 | Cu flakes; Cu & green residue on flask |
| Cu(tmhd)₂ | 70 ml | RT | 30 | 65 °C | 95 | Cu & green flakes; Cu & purple residue on flask |
| NiCl₂ | 50 ml | RT | 15 | 65 °C | 70 | Tan powder |
| CoCl₂ | 40 ml | RT | 35 | 65 °C | 60 | Dark green powder at RT (sticks to stir bar) |
| FeCl₂ | 60 ml | RT | 35 | 65 °C | 60 | Film on flask; black powder (sticks to stir bar) |
| ZnCl₂ | 75 ml | RT | 15 | 65 °C | 60 | Few metallic flakes → white precipitate after about 3 days |
| CrCl₂ | 70 ml | RT | 23 | 65 °C | 60 | Silver-colored flakes → grey suspension |
| MnCl₂ | 50 ml | RT | 15 | 65 °C | 60 | None |

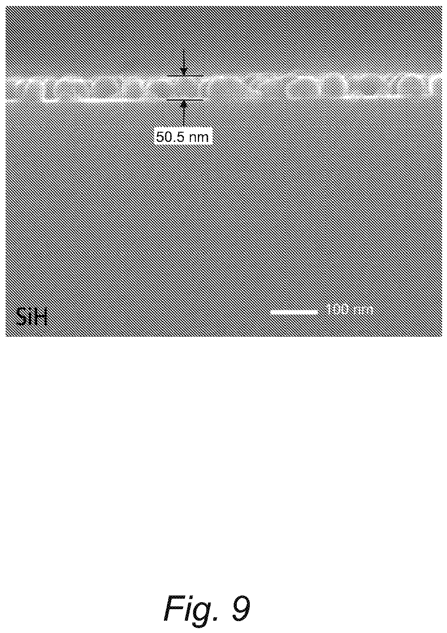

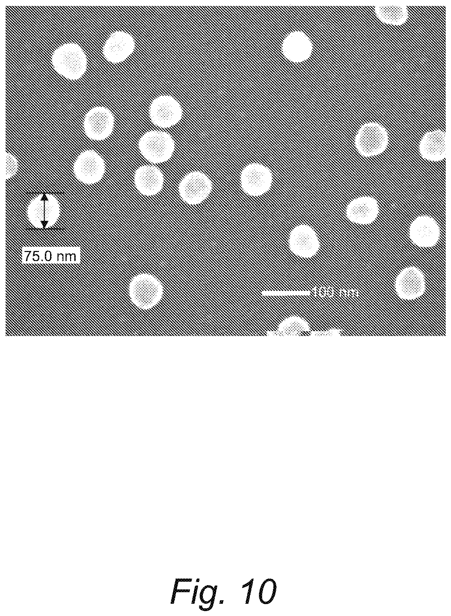

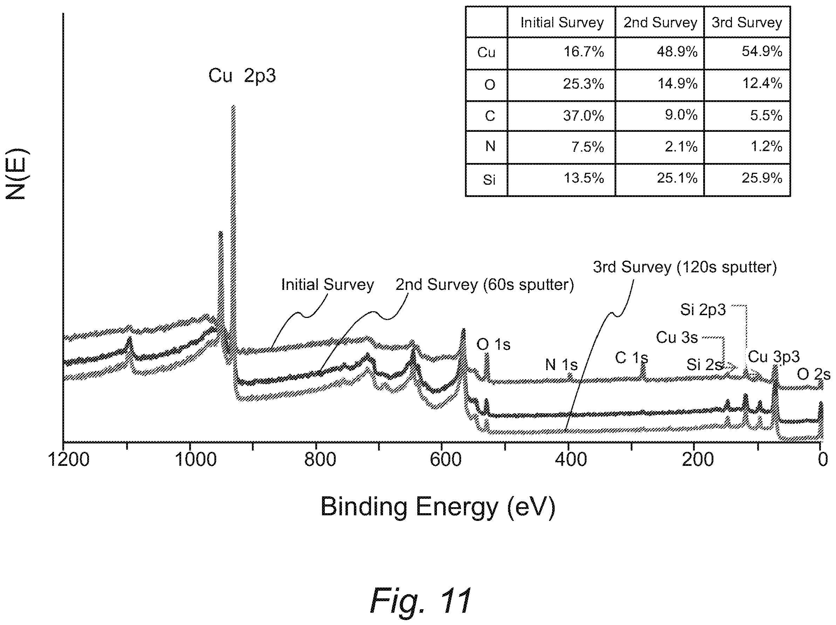

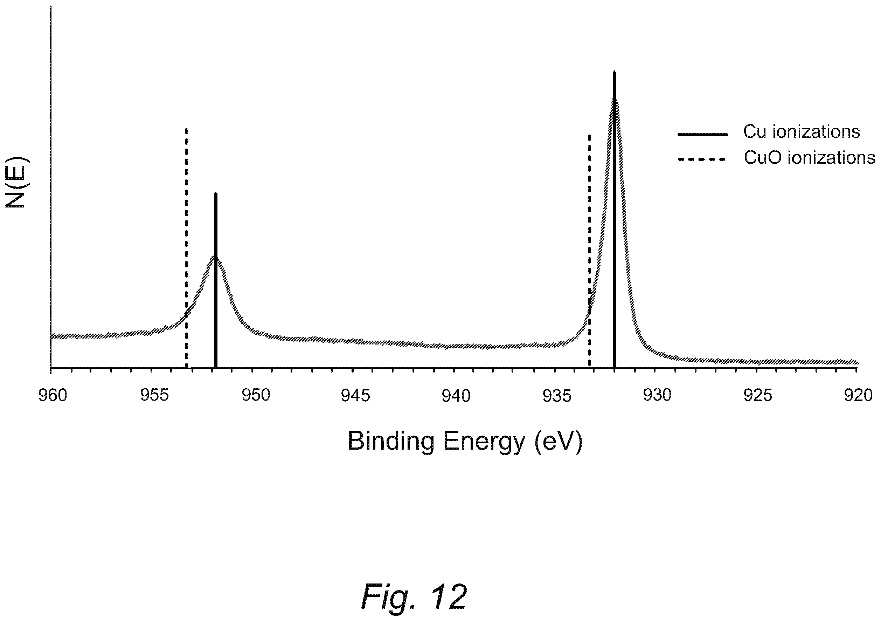

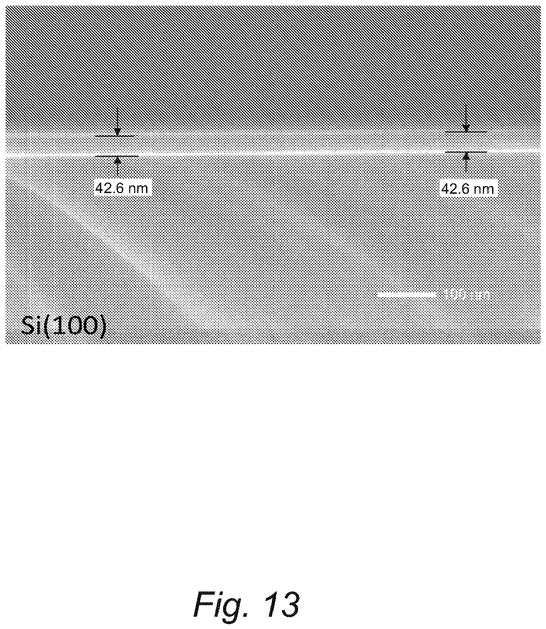

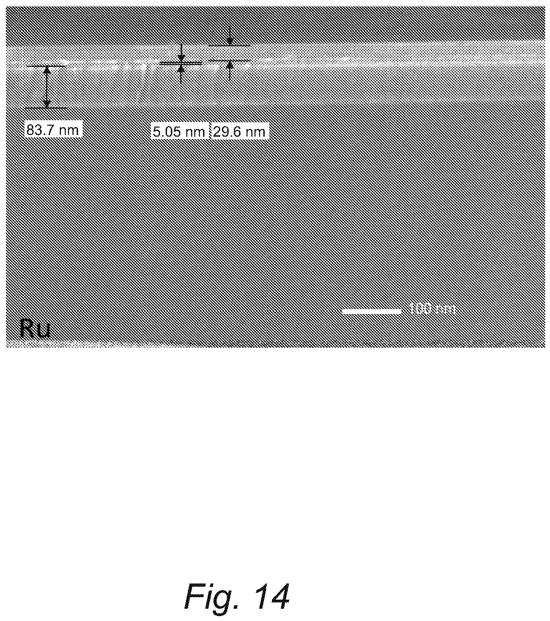

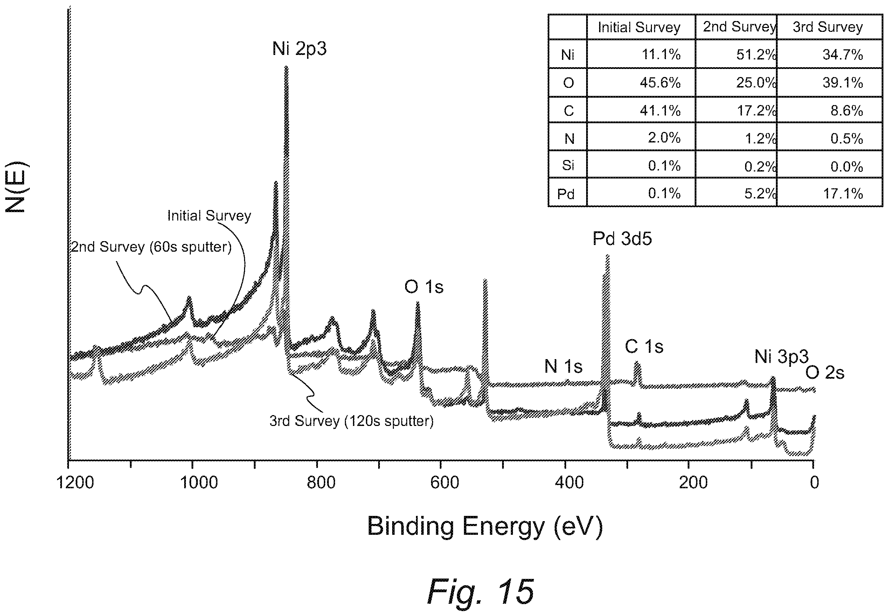

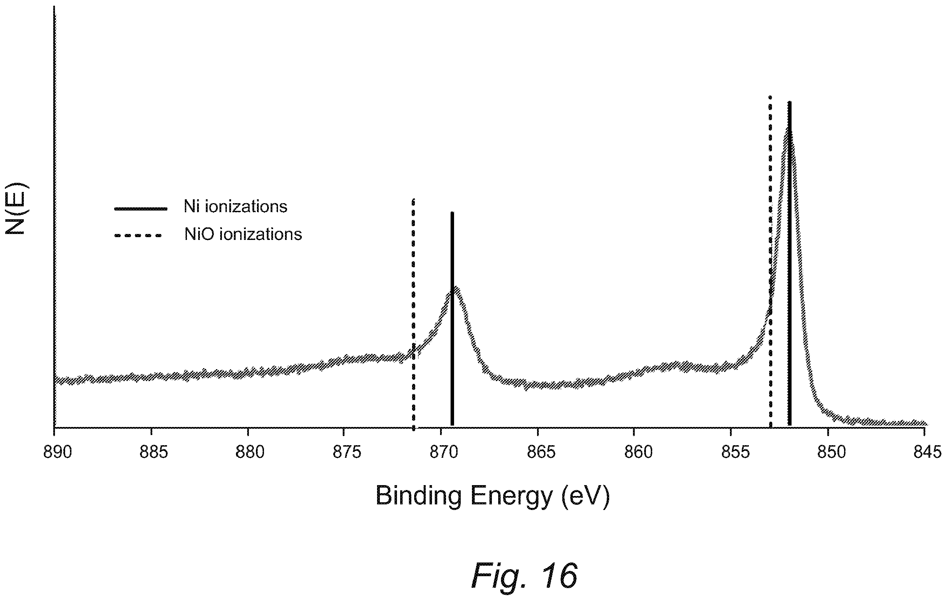

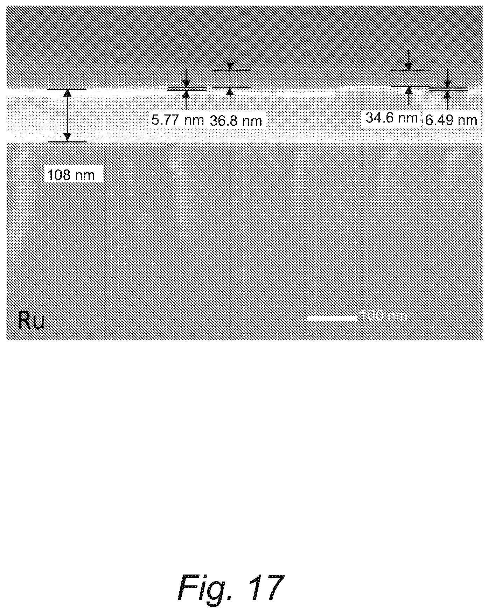

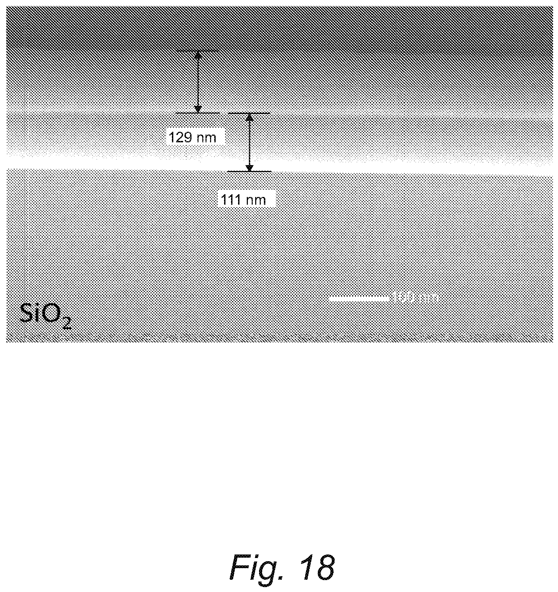

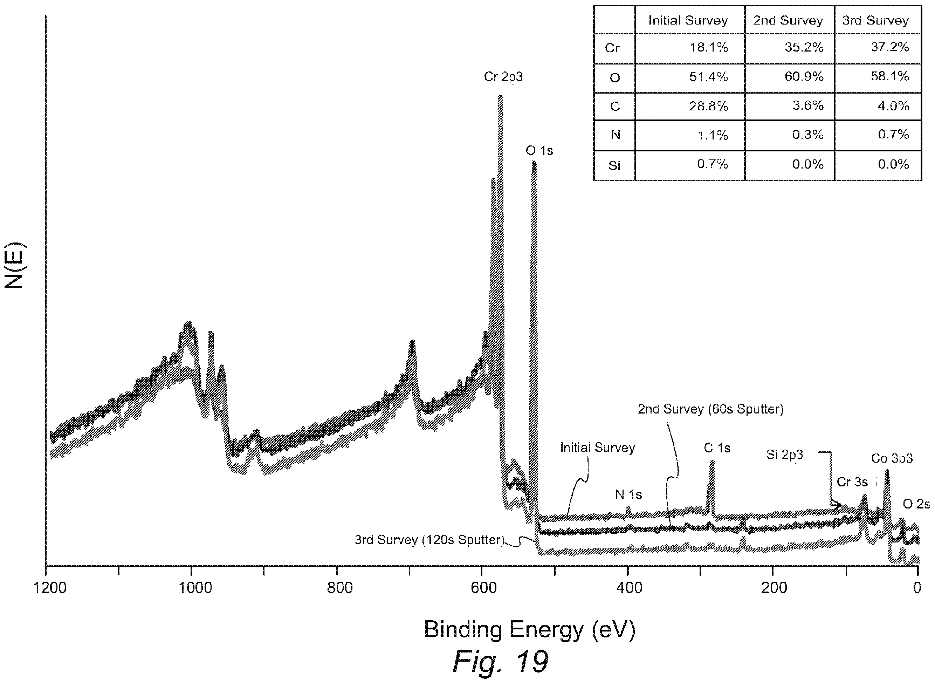

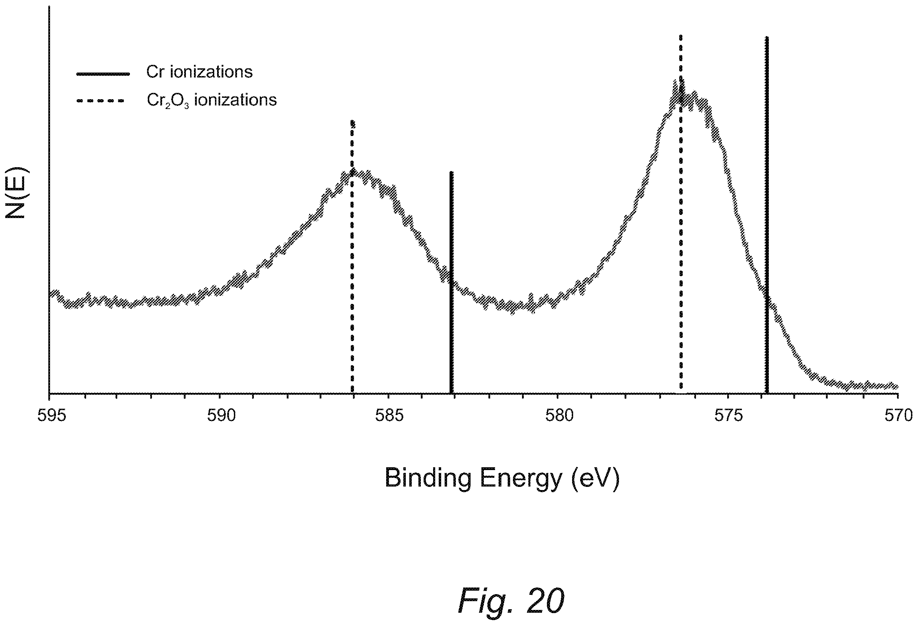

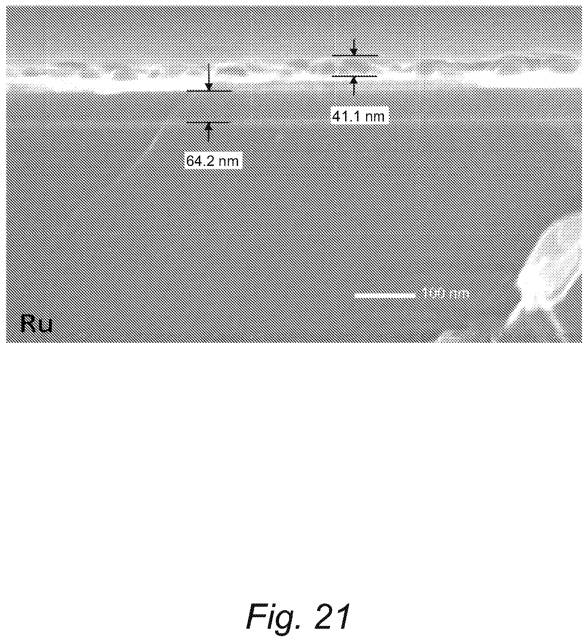

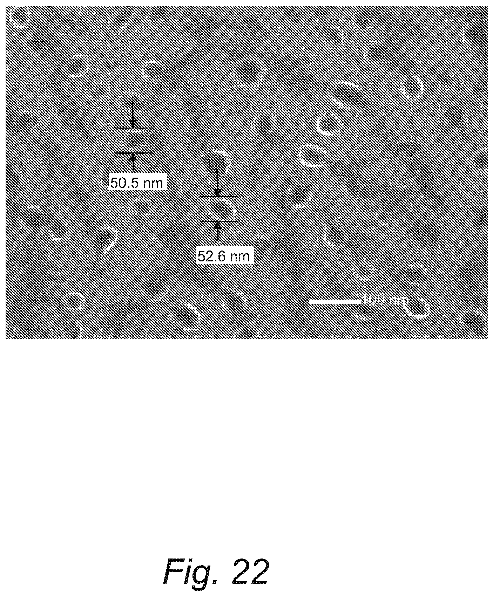

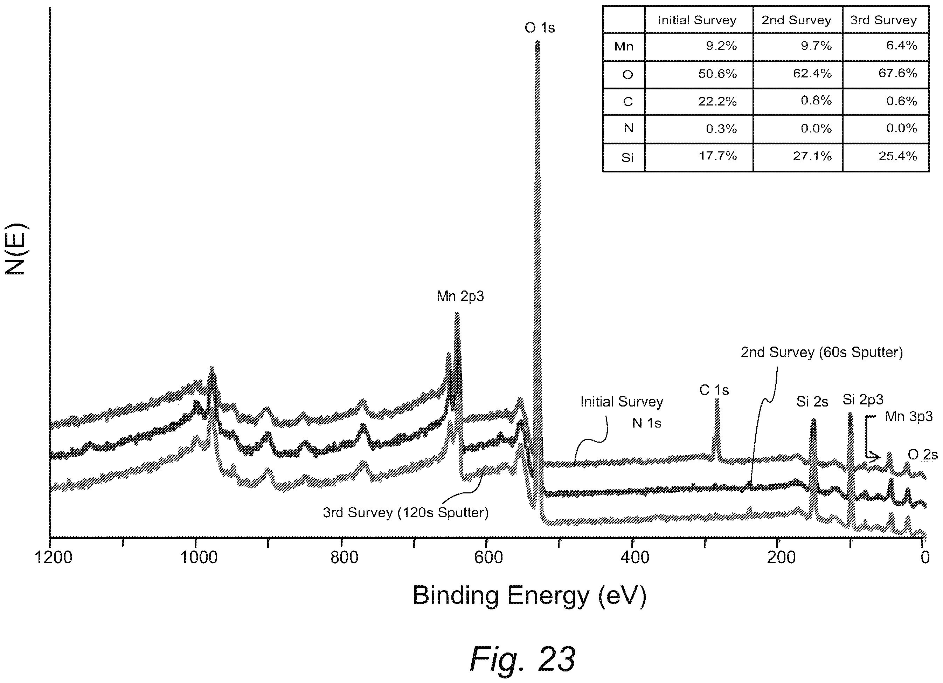

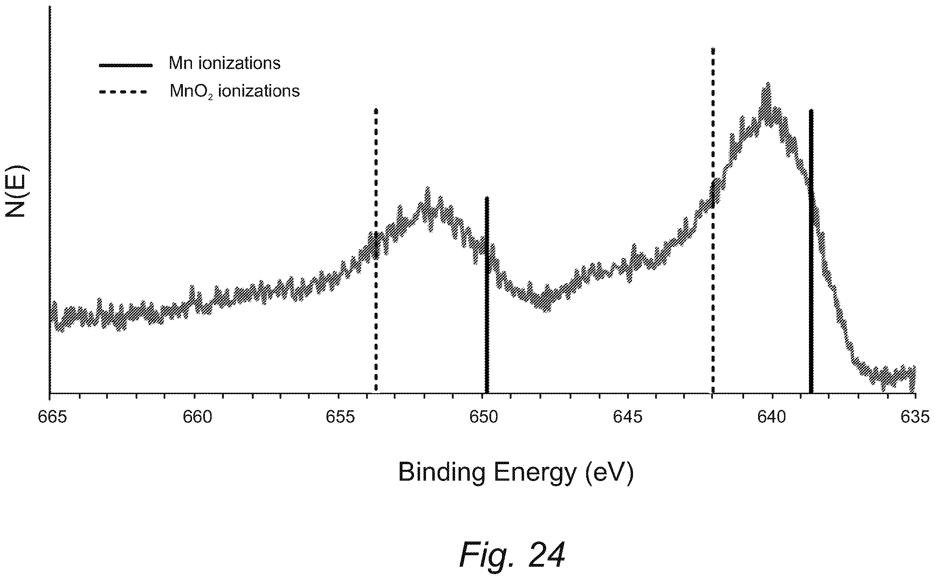

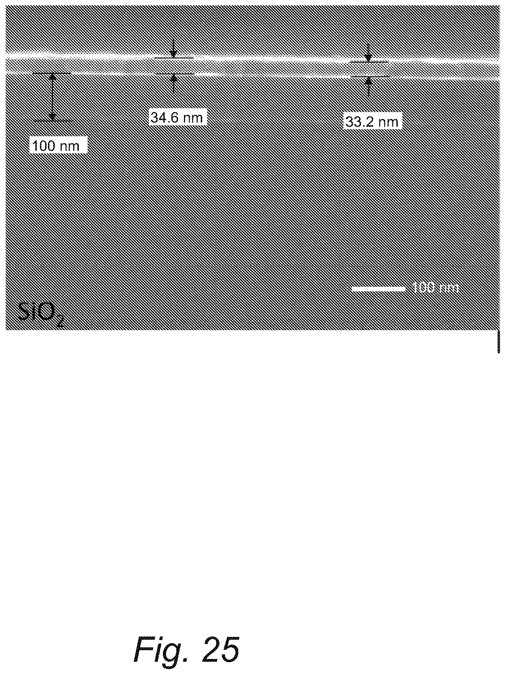

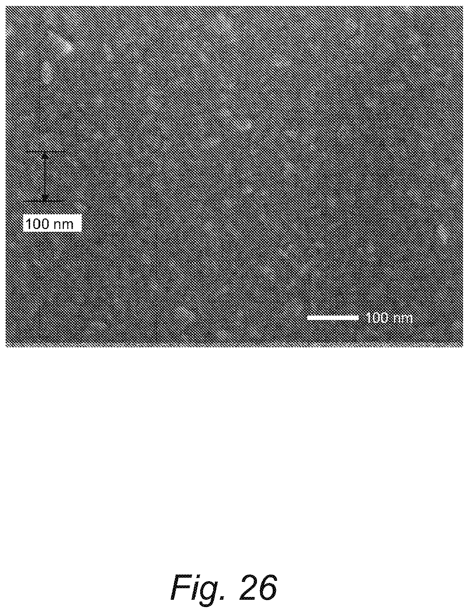

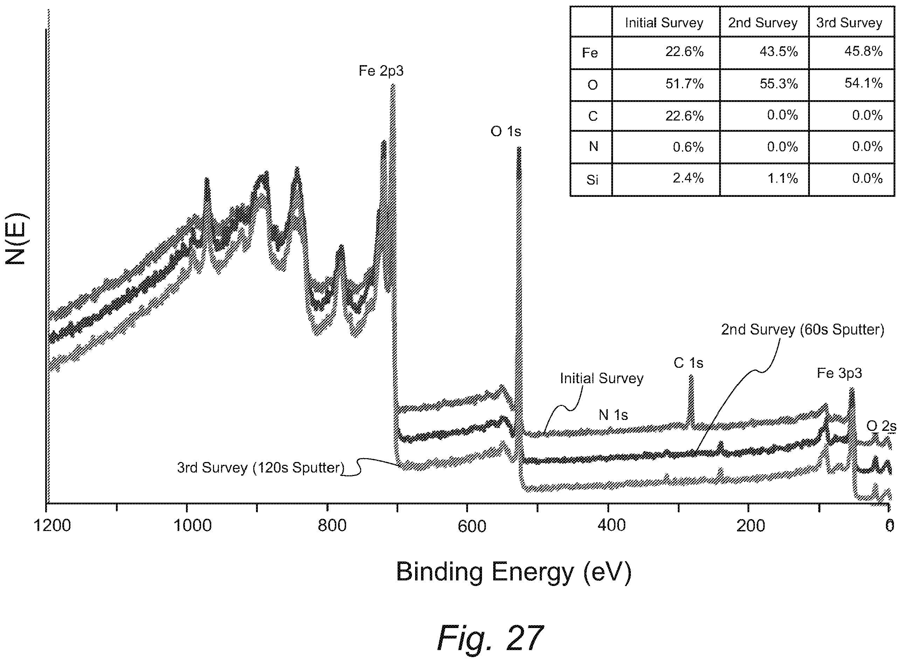

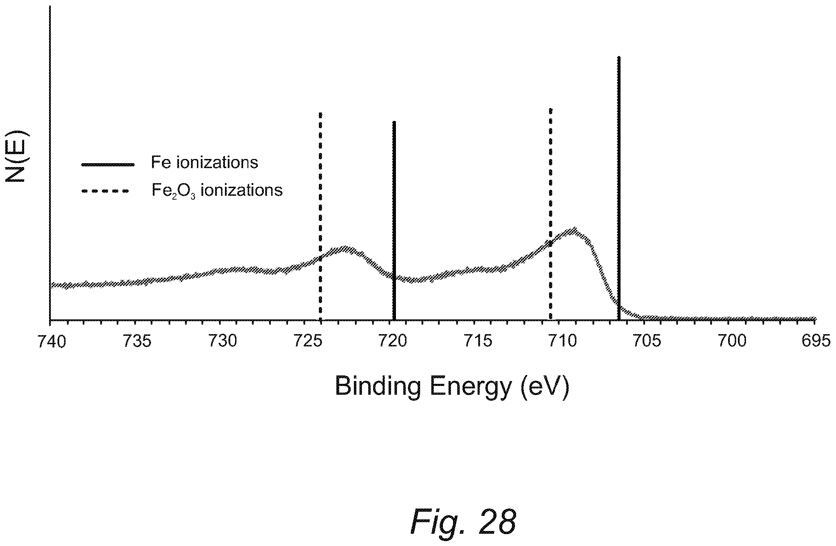

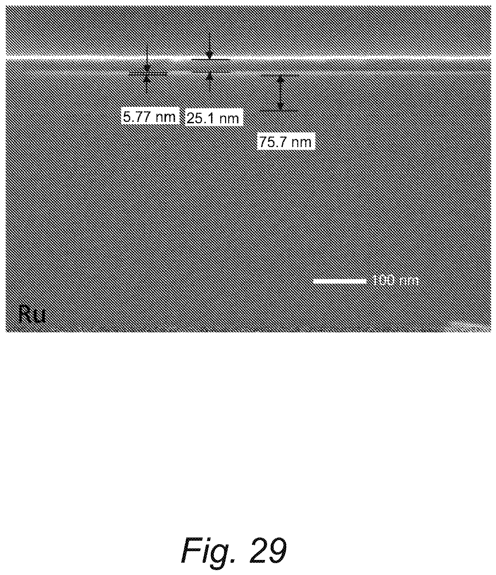

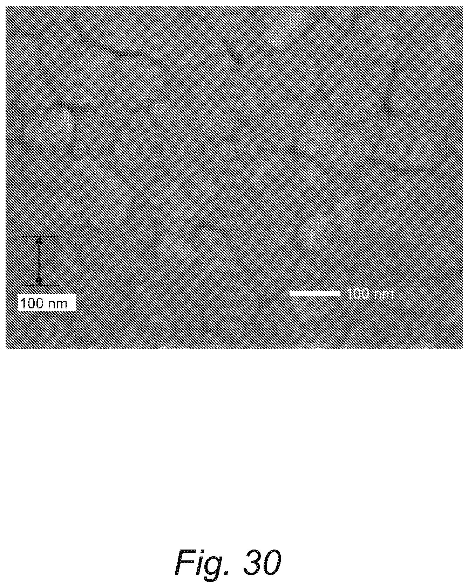

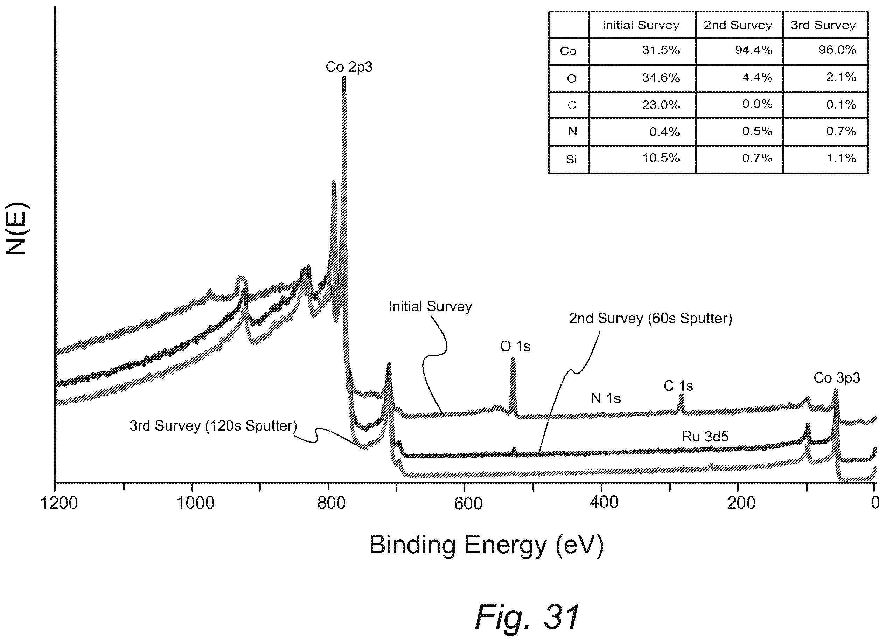

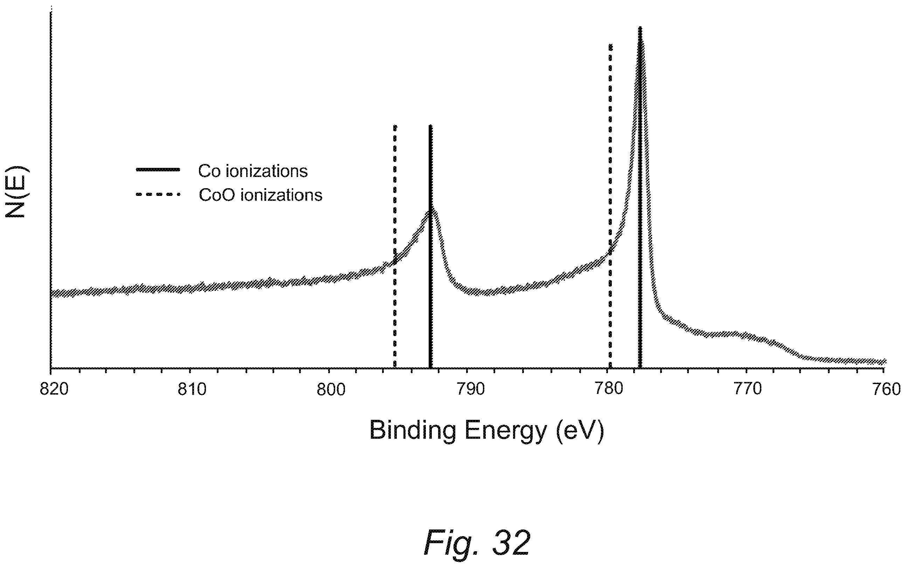

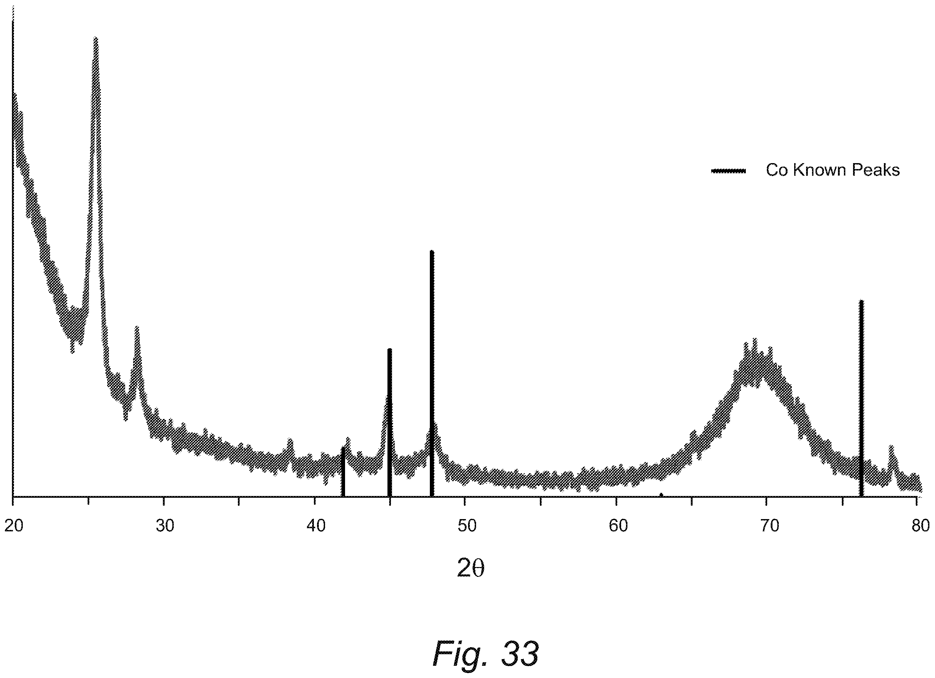

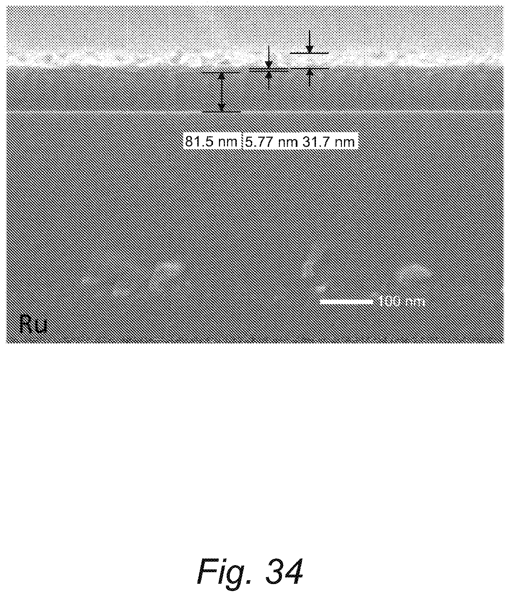

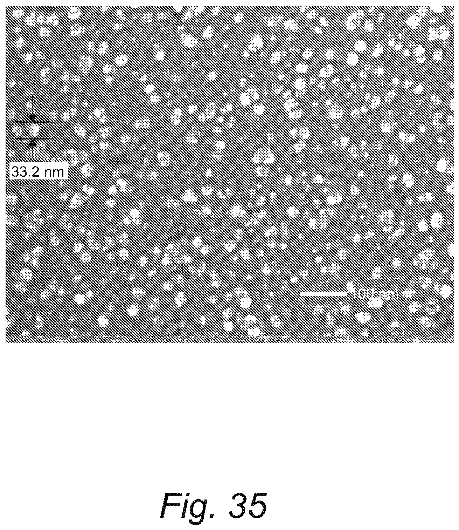

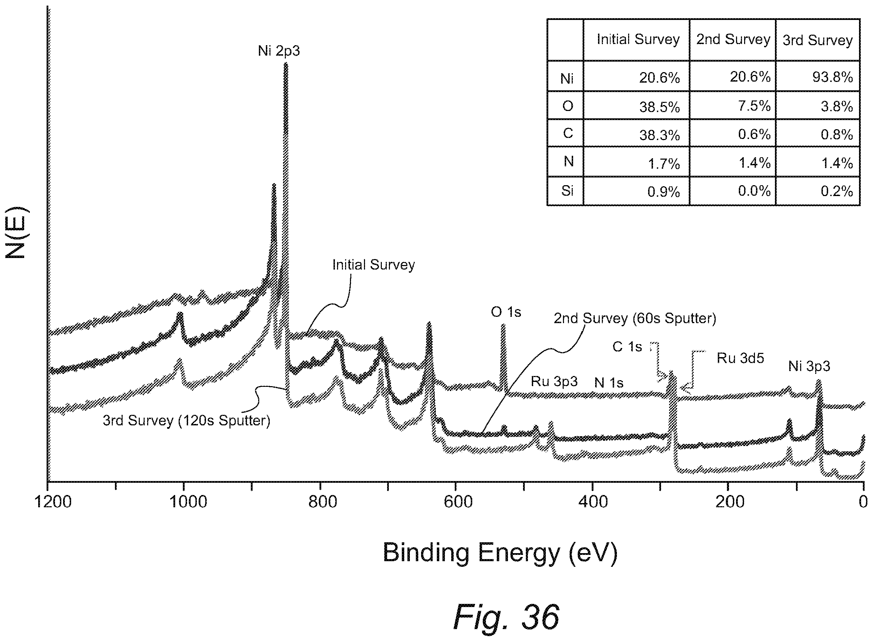

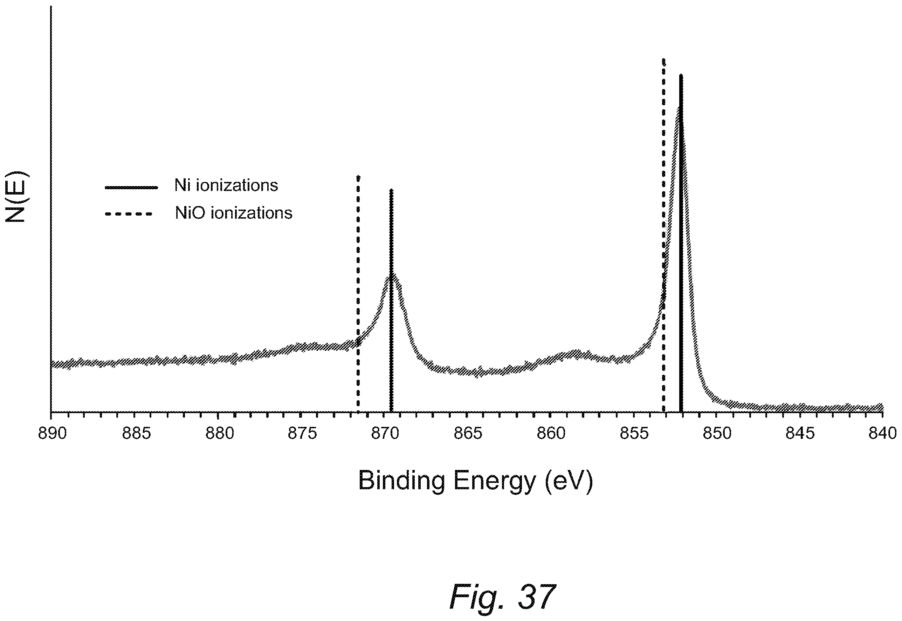

A binary process using Cu(dmap)₂ and DHP at 150 °C failed to produce films on any substrates (Si(100), SiH, thermal SiO₂, Cu, Pt, Pd, TiN, and Ru/SiO₂, Co/SiO₂). A three-step process was subsequently attempted, whereby formic acid was used to produce the metal formate, which was then reduced to copper metal by 1,4-bis(trimethylsilyl)-1,4-dihydropyrazine. Subsequent applications of this general approach used numerous metal precursors, including Cu and Ni(dmap)₂ and various metal 1,4-di-tert-butyldiazadiene complexes [M(dad^{tBu2})₂]. Each deposition cycle consisted of a precursor pulse (3.0 s for M(dmap)₂ and 6.0 s for M(dad^{tBu2})₂), a 5.0 s purge, a 0.2 s pulse of formic acid, a 5.0 s purge, a 1.0 s pulse of DHP , and a final 10.0 s purge. Delivery temperatures were maintained at 100 °C and 150 °C for M(dmap)₂ and M(dad^{tBu2})₂ precursors, respectively. Delivery temperatures were maintained at 70 °C and 21 °C for DHP and formic acid, respectively. Selected films from each deposition were characterized by SEM, XRD, and XPS as provided by Figures 9-37.

### Aluminum and Titanium Experimental Section

### Solution screening experiments:

### TiCl₄ + CHD (out of the scope of the claims)

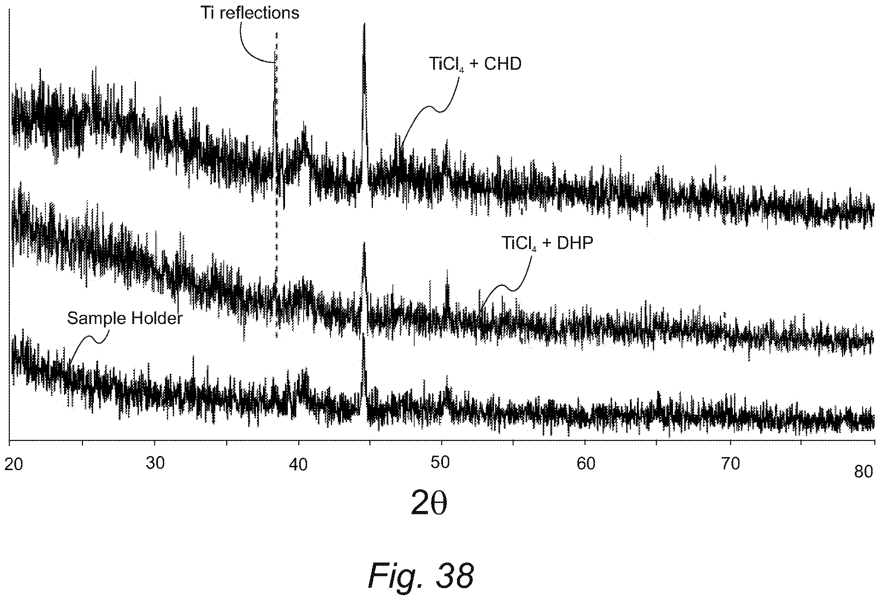

TiCl₄ was reacted with a 2.5 molar excess of CHD in toluene. Upon addition of the TiCl₄ to the CHD solution, the mixture turned a dark rust-brown color with a dark precipitate. The mixture was stirred at ambient temperature for ~ 24 hrs. The solvent was removed under vacuum using a hot water bath. XRD analysis of the precipitate powder showed the major reflection of Ti metal (2θ = 38.4°, Figure 38).

### TiCl₄ + DHP (out of the scope of the claims)

TiCl₄ was reacted with a 2.6 molar excess of DHP in toluene. TiCl₄ dissolved in toluene yielding a clear bright orange-colored solution. Upon addition of DHP, the solution immediately turned black with a very dark green/black precipitate. The mixture was stirred for ~ 24 hrs at ambient temperature. The solvent was removed under vacuum using a hot water bath. A small peak in the XRD spectrum matched that for the major reflection of Ti metal (2θ = 38.48, Figure 38). Figure 38 provides XRD patterns for solution reaction precipitates formed from the reaction with TiCl₄ and CHD and TiCl₄ and DHP. The spectra show peaks corresponding to titanium metal, thereby verifying the formation of titanium metal in the zero oxidation state.

### SiCl₄ + DHP (out of the scope of the claims)

DHP completely dissolved in 40 mL of toluene, yielding a yellow solution. SiCl₄ was directly added to the DHP solution, immediately producing a very faint white cloudiness near the bottom of the flask. The mixture was stirred at ambient temperature for ~ 72 hrs. A white precipitate was allowed to settle to the bottom of the flask. The solvent was removed under vacuum using a hot water bath. The yellow solution became increasingly dark as the solvent was removed; approximately 2-3 mL of liquid remained that would not evaporate. The remaining dark yellow slurry immediately turned brown upon air exposure. XRD analysis of the powder did not show any identifiable reflections.

### ALD Deposition experiments:

### TiCl₄ + CHD (out of the scope of the claims)

Titanium film growth was demonstrated using TiCl₄ + CHD. Each cycle consisted of a 0.2 s pulse of TiCl₄, a 15.0 s purge, a 1.0 s pulse of CHD, and a 10.0 s purge. The TiCl₄ bubbler was maintained at 20 °C and the reaction chamber was held at 180 °C. The temperature of the solid state booster for CHD delivery was set to 75 °C. After 1,000 cycles, definitive films were observed on Pd, Pt, and SiO₂ with growth rates of approximately 0.09 Å/cycle, 0.15 Å/cycle, and 0.08 Å/cycle, respectively. Discontinuous (island-type) growth was observed by SEM on the Co substrate. Faint films were observed on the Ru and Cu substrates; their presence was confirmed by SEM analysis.

As used herein for the ALD experiments, platinum substrates consist of silicon substrates with a thermal oxide over coated with a platinum layer. Palladium substrates consist of silicon substrates with a thermal oxide over coated with a palladium layer. Cobalt substrates consist of silicon substrates with a thermal oxide over coated with a cobalt layer. It should be appreciated that SEM cross-sections are not able to distinguish the metal coating the substrate and the ALD film deposited thereon.

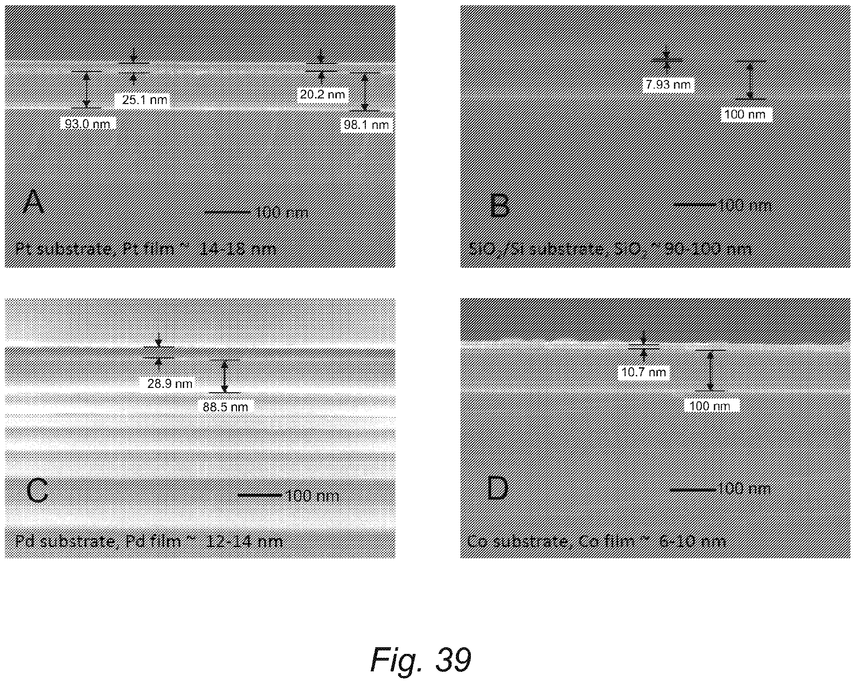

Figure 39A provides an SEM cross-section for an ALD film deposited on a platinum substrate from the reaction with TiCl₄ and CHD at 180° C. From the micrograph, the combined platinum and titanium thickness is about 25 nm with an approximate platinum layer thickness of about 14 to 18 nm and a titanium layer thickness from 7 to 11 nm. Figure 39B provides an SEM cross-section for an ALD film deposited on a silicon substrate with a thermal silicon oxide layer from the reaction with TiCl₄ and CHD at 180° C. From the micrograph, the titanium layer thickness is about 8 nm. Figure 39C provides an SEM cross-section for an ALD film deposited on a palladium substrate from the reaction with titanium tetrachloride and CHD at 180° C. From the micrograph, the combined palladium and titanium thickness is about 29 nm with an approximate palladium layer thickness of about 12 to 14 nm and a titanium layer thickness from 15 to 17 nm. Figure 39D provides an SEM cross-section for an ALD film deposited on a cobalt substrate from the reaction with titanium tetrachloride and CHD at 180° C. From the micrograph, the combined cobalt and titanium thickness is about 11 nm with an approximate cobalt layer thickness of about 6 to 10 nm and titanium layer thickness of about 1 to 5 nm.

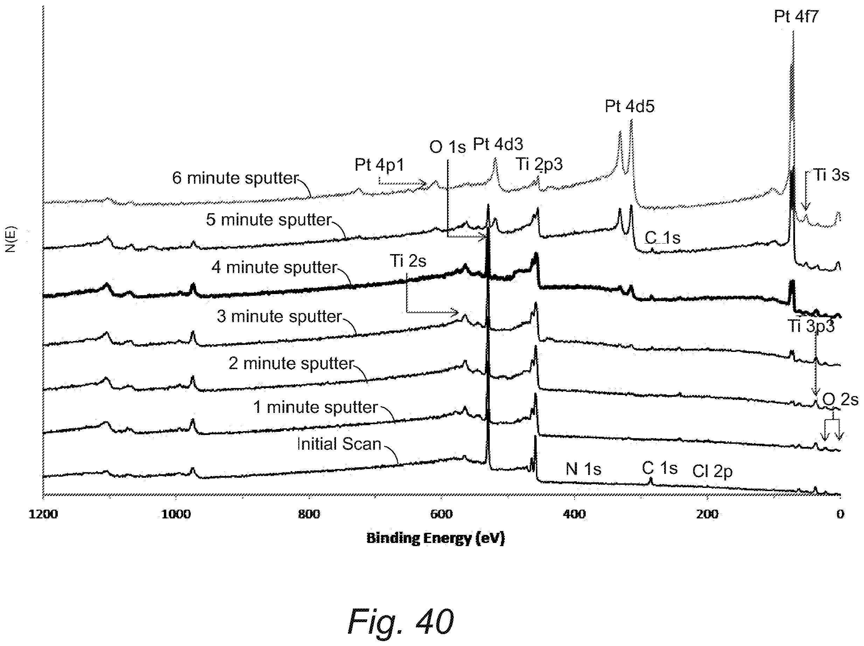

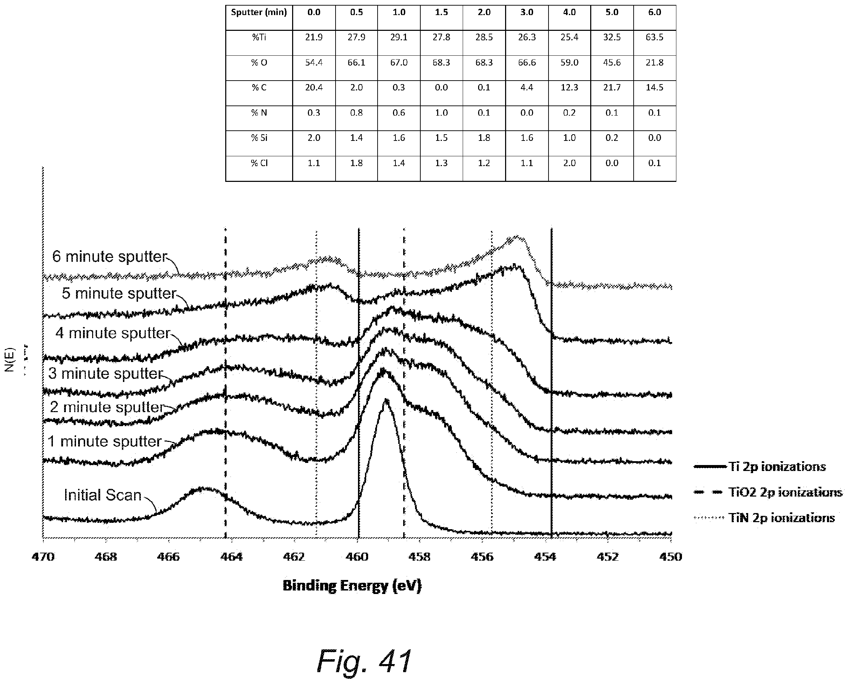

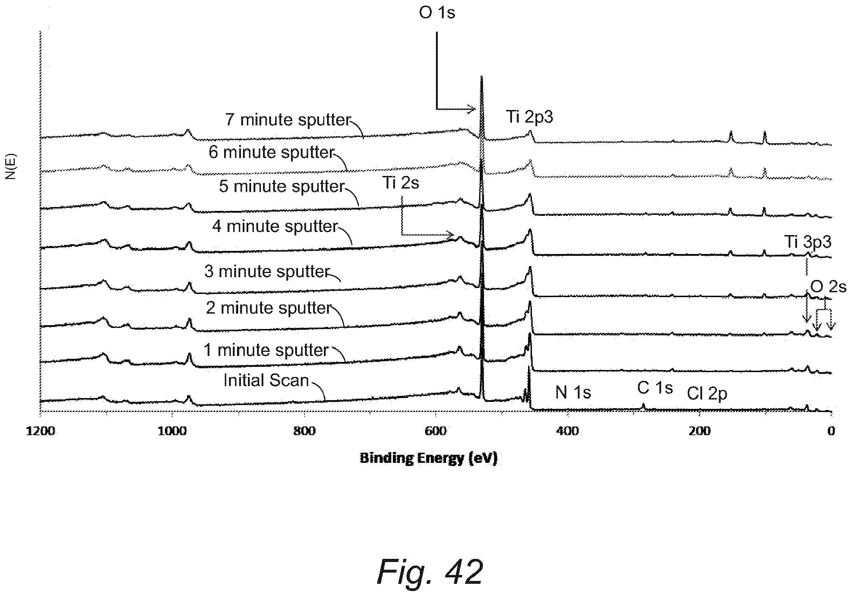

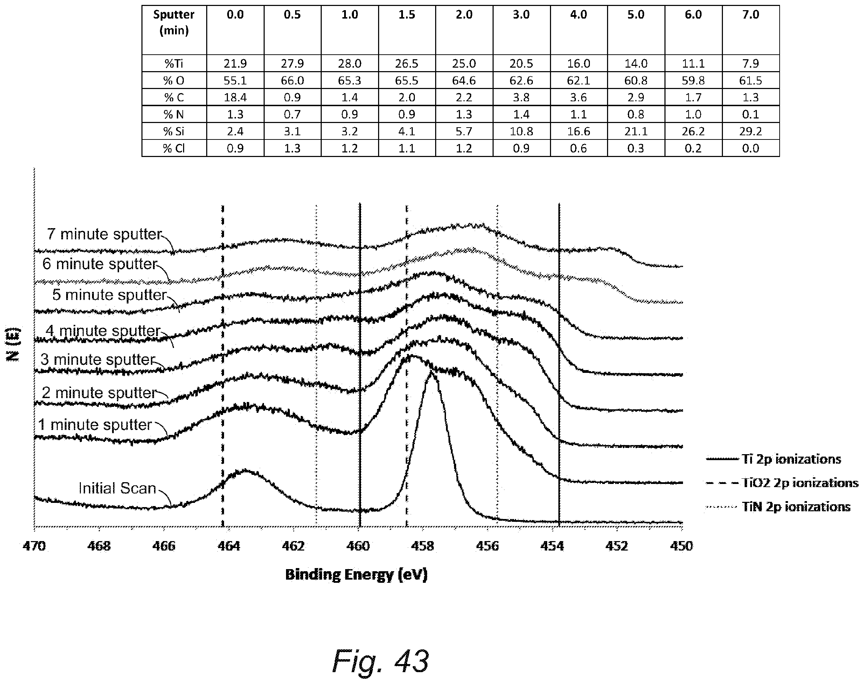

Figures 40 and 41 respectively show XPS survey scans and XPS multiplex scans for an 8 nm ALD film deposited on a platinum substrate by reacting TiCl4 and CHD at 180 C. The scans confirm the presence of a titanium-containing film. Figures 42 and 43 respectively show XPS survey scans and XPS multiplex scans for an 8 nm ALD film deposited on a silicon oxide coated silicon substrate by reacting TiCl4 and CHD at 180 C. The scans confirm the presence of a titanium-containing film.

### TiCl₄ + DHP (out of the scope of the claims)

Titanium film growth was demonstrated using TiCl₄ + DHP. Each cycle consisted of a 0.2 s pulse of TiCl₄, a 15.0 s purge, a 1.0 s pulse of DHP, and a 10.0 s purge. The TiCl₄ bubbler was maintained at 20 °C and the reaction chamber was held at 100 °C. The temperature of the solid state booster for DHP delivery was set to 75 °C. After 3,000 cycles, definitive film growth was achieved on Pd, Pt, TiN, Co, Cu, Ru, Si(100), and SiO₂. Average approximate growth rates were determined by SEM analysis: Pd (0.04 Å/cycle), Pt (0.11 Å/cycle), TiN (0.04 Å/cycle), Co (0.13 Å/cycle), Cu (0.11 Å/cycle), Ru (0.08 Å/cycle), Si (0.11 Å/cycle), and SiO₂ (0.12 Å/cycle).

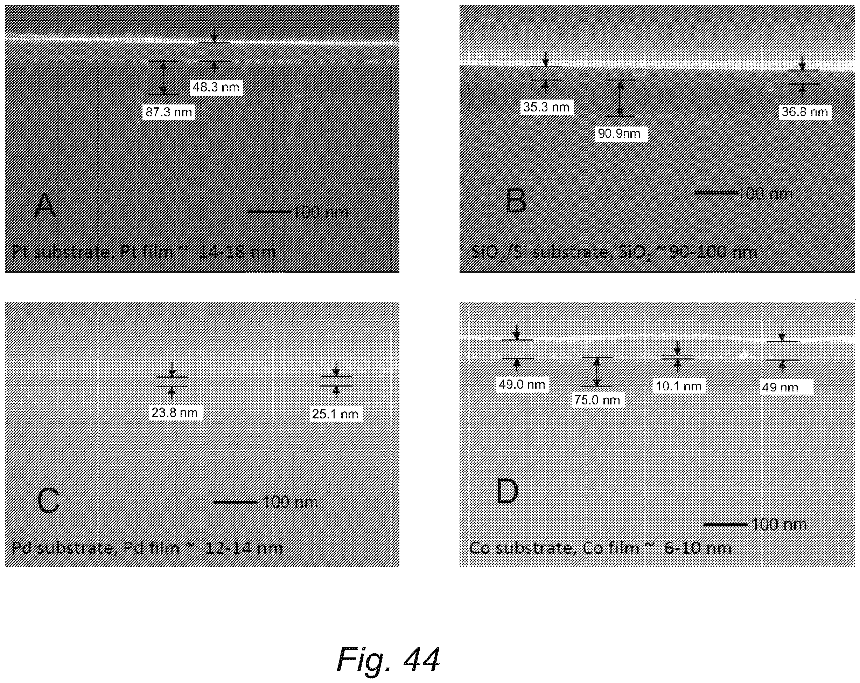

Figure 44A provides an SEM cross-section for an ALD film deposited on a platinum substrate from the reaction with titanium tetrachloride and DHP. From the micrograph, the combined platinum and titanium thickness is about 48 nm with an approximate platinum layer thickness of about 14 to 18 nm and a titanium layer thickness from 30 to 34 nm. Figure 44B provides an SEM cross-section for an ALD film on a silicon substrate with a thermal silicon oxide layer from the reaction with titanium tetrachloride and DHP. From the micrograph, the titanium layer thickness is about 35 nm. Figure 44C provides an SEM cross-section for an ALD film on a palladium substrate from the reaction with titanium tetrachloride and DHP. From the micrograph, the combined palladium and titanium thickness is about 24 nm with an approximate palladium layer thickness of about 12 to 14 nm and a titanium layer thickness of about 10 to 12 nm. Figure 44D provides an SEM cross-section for an ALD film on a cobalt substrate from the reaction with titanium tetrachloride and DHP. From the micrograph, the combined cobalt and titanium thickness is about 48 nm with an approximate titanium layer thickness of about 6 to 10 nm and a titanium layer thickness of about 38 to 42 nm.

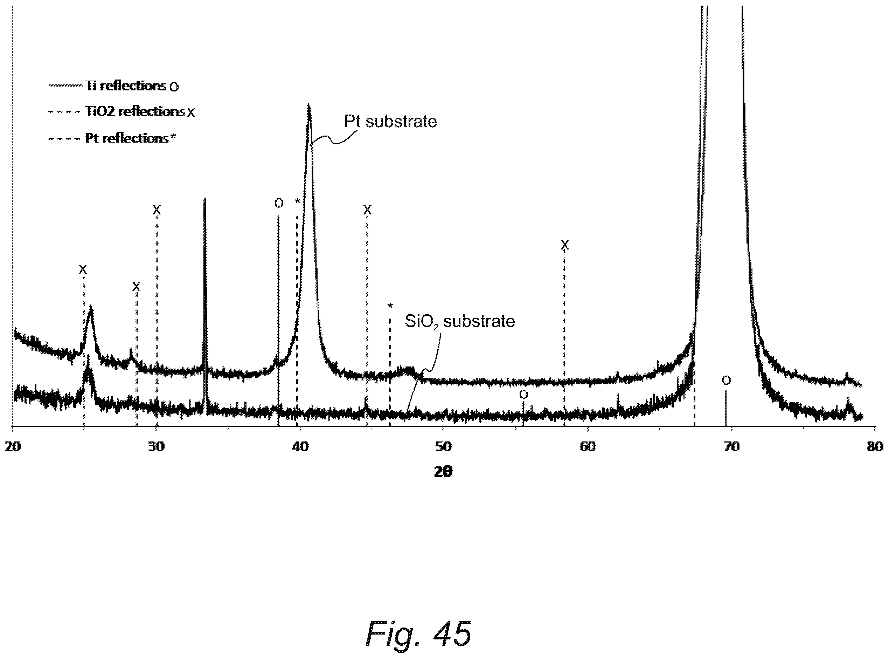

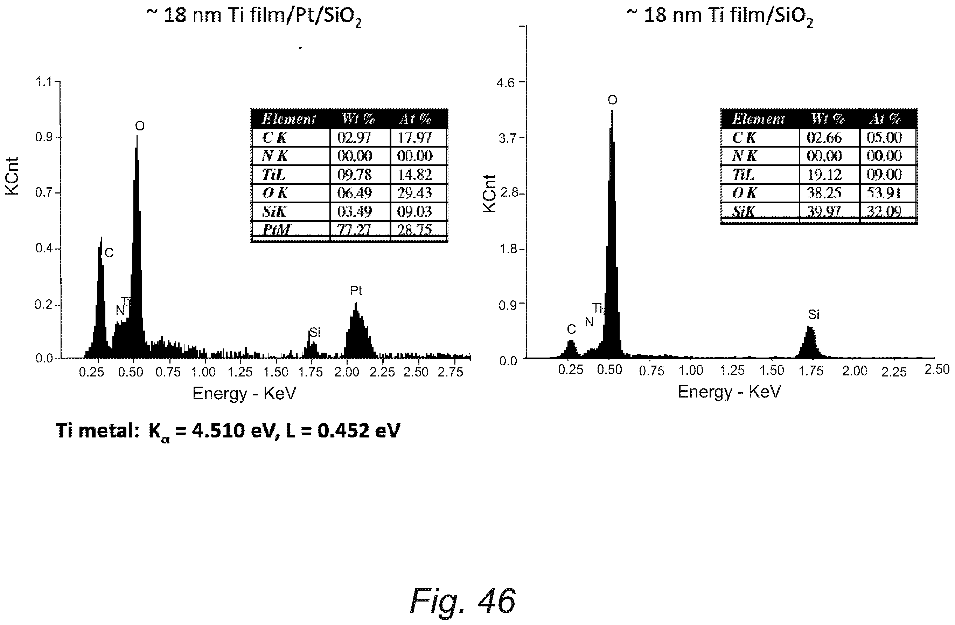

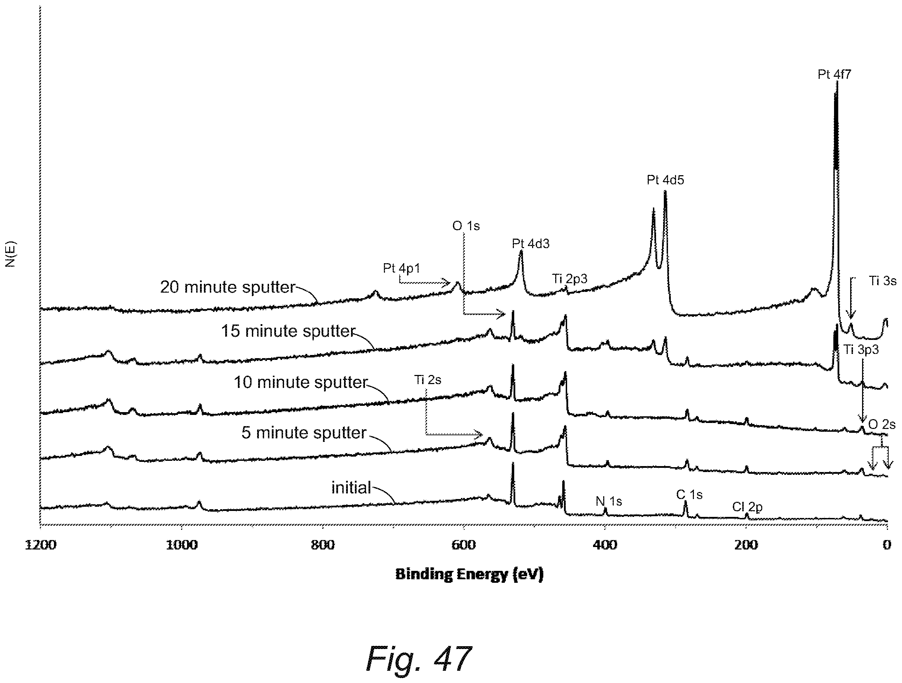

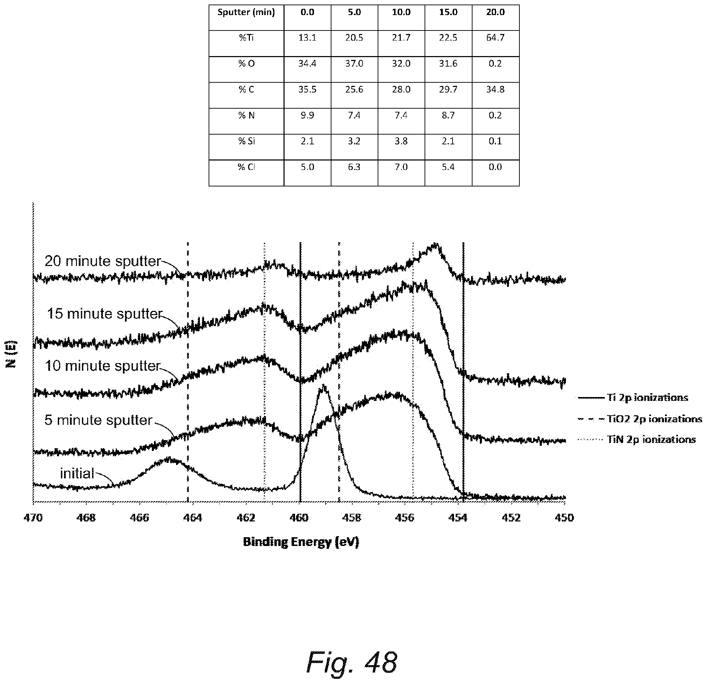

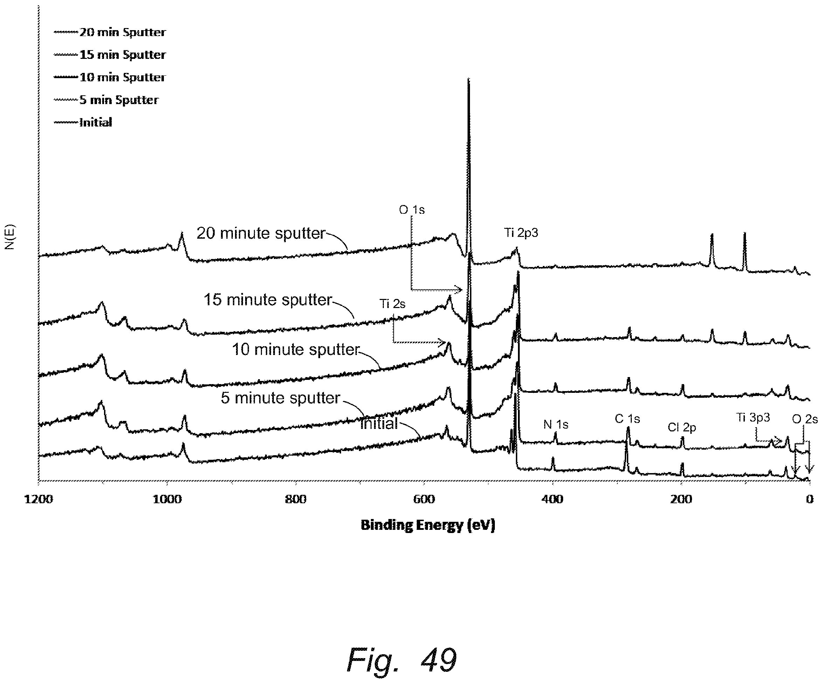

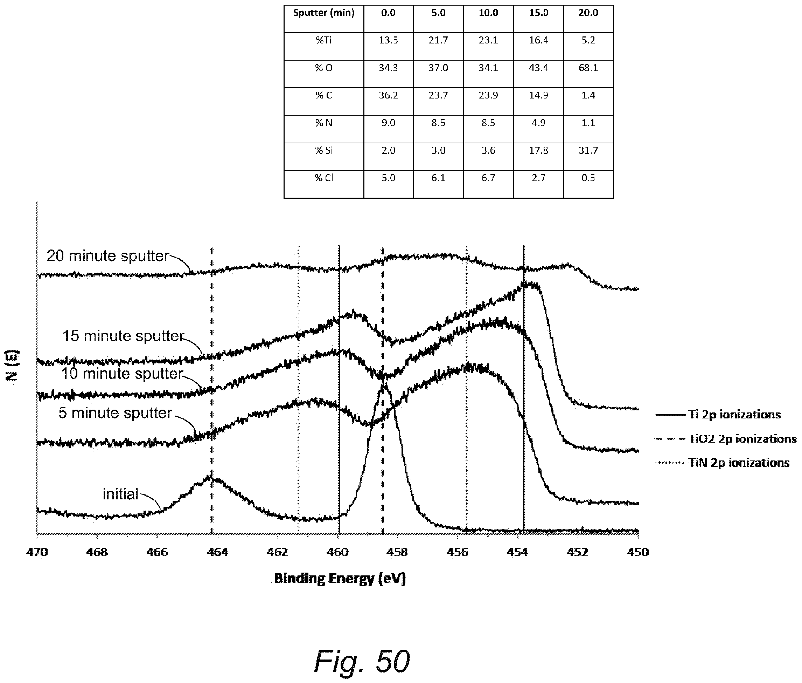

Figure 45 provides X-ray diffraction (XRD) spectra for ALD films formed from the reaction with TiCl₄ and DHP on platinum substrates and silicon oxide substrates. It should be noted that the major Ti reflection appears on the Pt substrate as a minor component (2θ = 38.48°) and the major TiO₂ reflection appears on the SiO₂ substrate as a minor component (2θ = 44.67°). The thicknesses of the titanium films are about 30 to 35 nm. Figure 46 provides EDS spectra for ALD films formed from the reaction with TiCl₄ and DHP on platinum substrates and silicon oxide substrates. The oxide film gradually changes in oxidation state from TiO₂ → Ti₂O₃ → TiO → (by XPS analysis). It is hypothesized that oxide growth is controlled by oxygen diffusion through the existing oxide film (Brunette, D.M.; Tengvall, P.; Textor, M.; Thomsen, P. Titanium in Medicine; Springer, 2001; pp. 178-182). Finally, the thickness of the interfacial gradient layer is 39 ± 2 nm for polished commercially prepared titanium by RBS analysis (Brunette, D.M.; Tengvall, P.; Textor, M.; Thomsen, P. Titanium in Medicine; Springer, 2001; pp. 178-182). Figures 47 and 48, respectively, show XPS survey scans and XPS multiplex scans for a 34 nm ALD film deposited on a platinum substrate by reacting TiCl4 and DHP at 100 C. The scans confirm the presence of a titanium-containing film. Figures 49 and 50, respectively, show XPS survey scans and XPS multiplex scans for a 35 nm ALD film deposited on a silicon oxide coated silicon substrate by reacting TiCl4 and DHP at 100 C. The scans confirm the presence of a titanium-containing film.

### Al(CH₃)₃ + DHP (out of the scope of the claims)

Aluminum film growth was demonstrated using Al(CH₃)₃ and DHP. Each cycle consisted of a 0.1 s pulse of Al(CH₃)₃, a 8.0 s purge, a 1.0 s pulse of DHP, and a 10.0 s purge. The temperature of the Al(CH₃)₃ and DHP bubblers were 20 °C and 70 °C, respectively. The reaction chamber was maintained at 180 °C. After 1,000 cycles, films were observed on the Co and SiO₂ substrates. The film on SiO₂ was very thin, but observable by SEM. The growth rate on the Co substrate was approximately 0.15 Å/cycle.

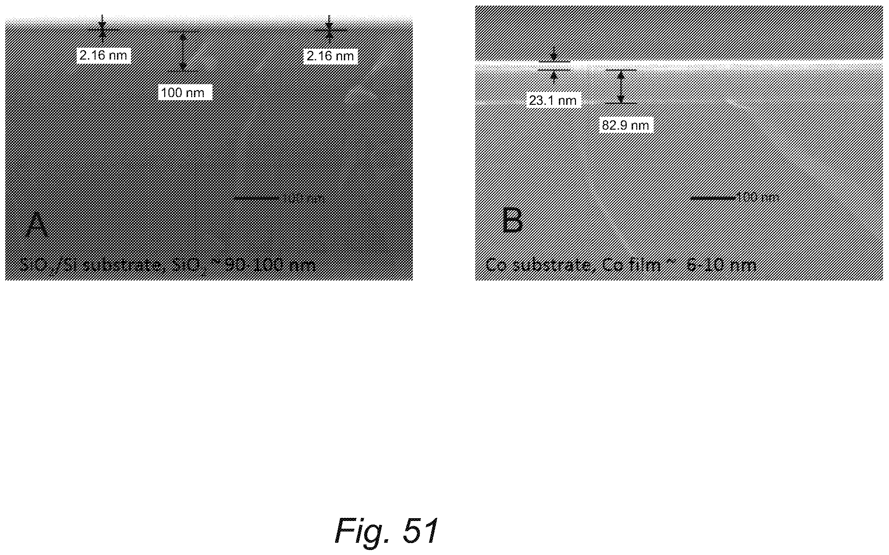

Figure 51A provides a SEM cross-section for an aluminum-containing film deposited on a silicon oxide coated silicon substrate from trimethylaluminum and DHP at 180° C. From the micrograph, the aluminum layer thickness of about 2 nm. Figure 51B provides a SEM cross-section for an aluminum-containing film deposited on a cobalt-coated silicon substrate from trimethylaluminum and DHP at 180° C. From the micrograph, the combined cobalt and aluminum thickness is about 23 nm with the cobalt layer having a thickness from about 6 to 10 nm and the aluminum layer having a thickness from about 13 to 17 nm.

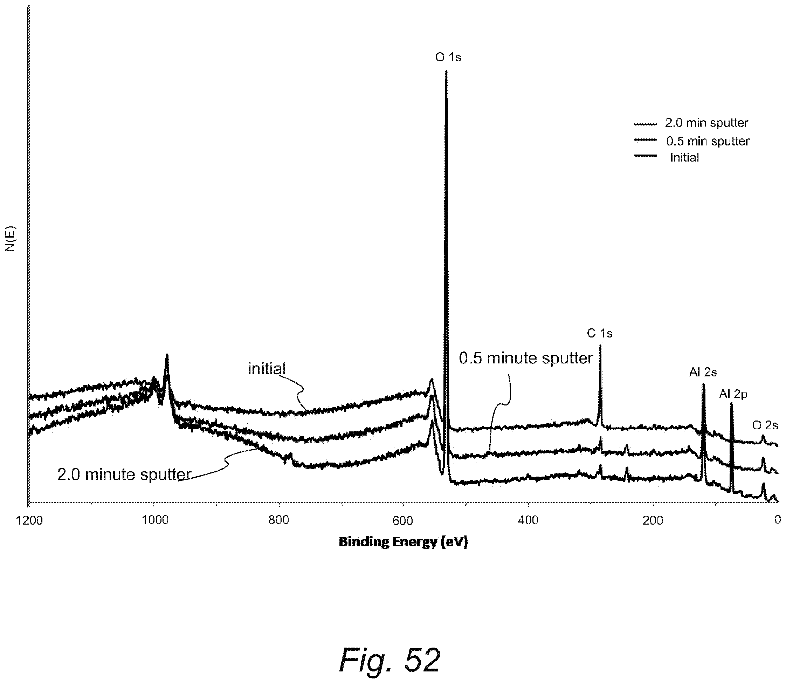

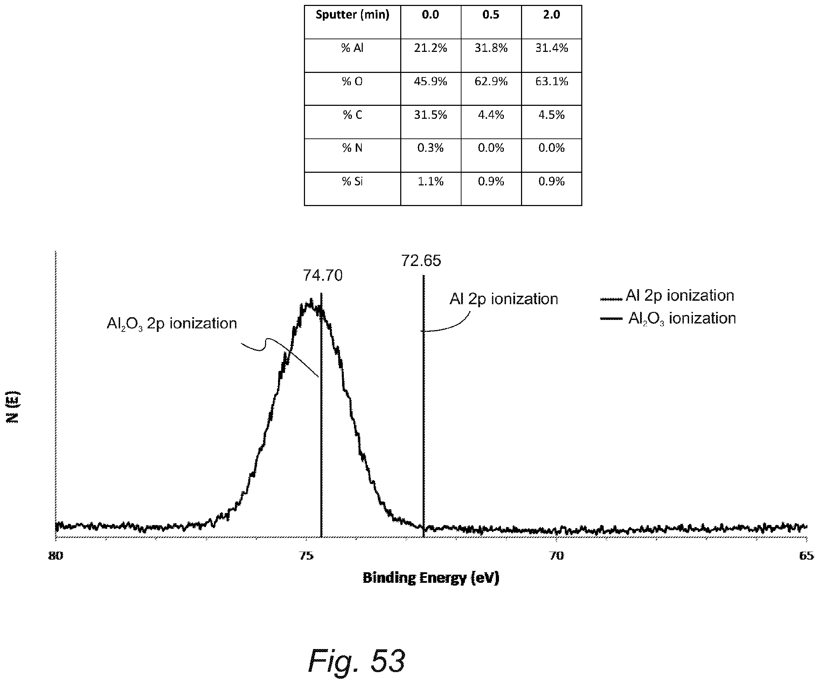

Figures 52 and 53 respectively show XPS survey scans and XPS multiplex scans for a 15 nm film deposited on a cobalt-coated substrate by reacting trimethylaluminum and DHP at 180 C . The scans confirm the presence of an aluminum-containing film.

### SbCl₃ + DHP (out of the scope of the claims)

Antimony film growth was demonstrated using SbCl₃ and DHP. Each cycle consisted of a 5.0 s pulse of SbCl₃, a 15.0 s purge, a 1.0 s pulse of DHP, and a 10.0 s purge. The temperature of the solid state booster for SbCl₃ delivery was set to 40 °C. The DHP bubbler was set to 70 °C and the reaction chamber was held at 180 °C. After 1,000 cycles, films were deposited on Cu, Pt, and Pd substrates. A growth rate of 0.20 Å/cycle was achieved on the Pt substrate. Growth on the Cu and Pd substrates was non-uniform and granular. Analysis by top-down SEM revealed dense crystalline morphologies on the Pt and Pd substrates.

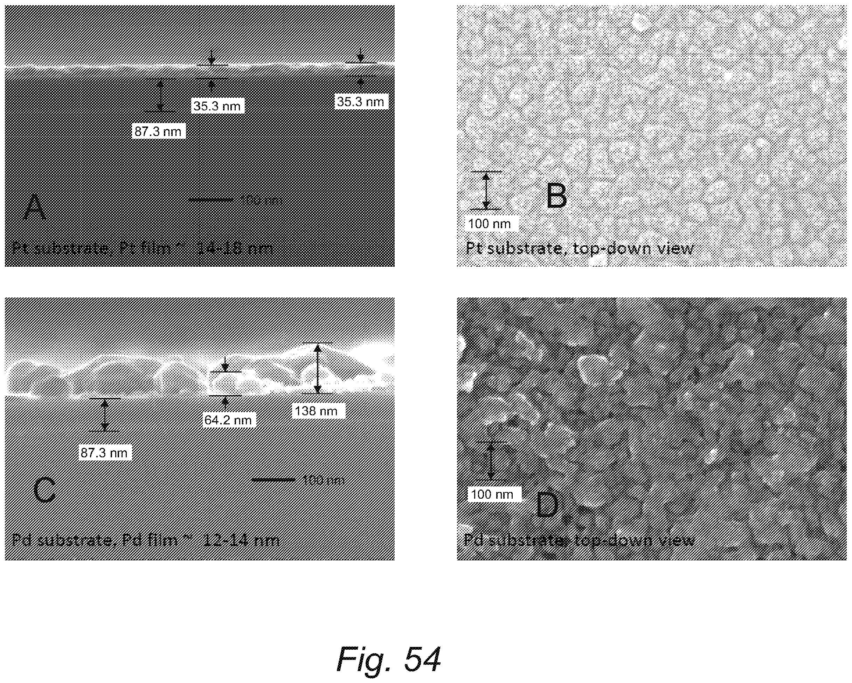

Figure 54A provides an SEM cross-section for an ALD film deposited on a platinum substrate from SbCl₃ and DHP at 180° C. From the micrograph, the combined platinum and antimony thickness is about 35 nm with the cobalt layer having a thickness from about 14 to 18 nm and the antimony layer having a thickness from about 17 to 21 nm. Figure 54B provides an SEM top-down view for an ALD film deposited on a platinum substrate from antimony trichloride and DHP at 180° C. Figure 54C provides an SEM cross-section for an ALD film deposited on a palladium substrate from SbCl₃ and DHP at 180° C. From the micrograph, the combined platinum and antimony thickness is about 64 to 136 nm with the cobalt layer having a thickness from about 12 to 14 nm and the antimony layer having a thickness from about 50 to 124 nm. This film is granular and highly non-uniform.

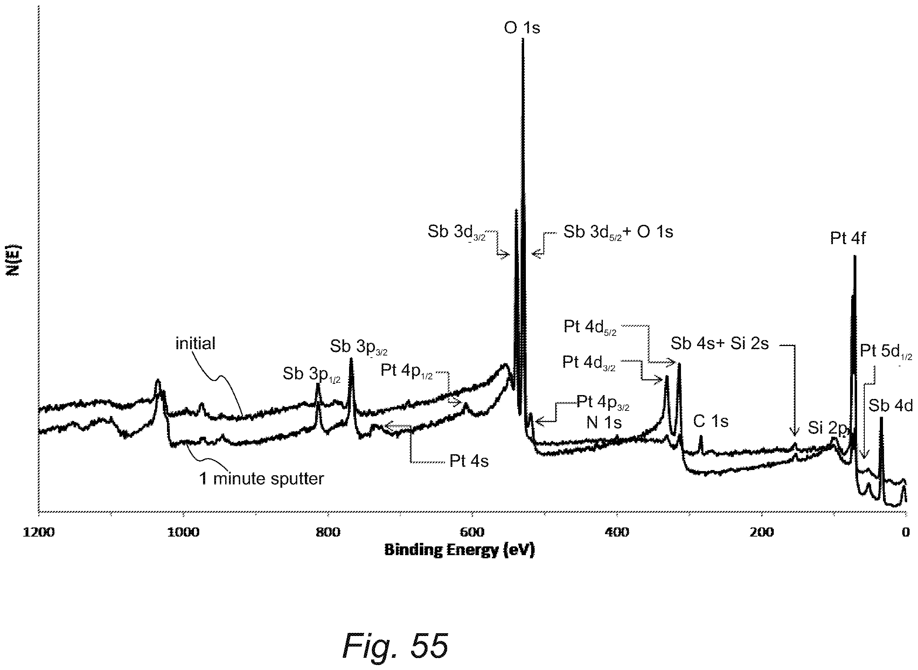

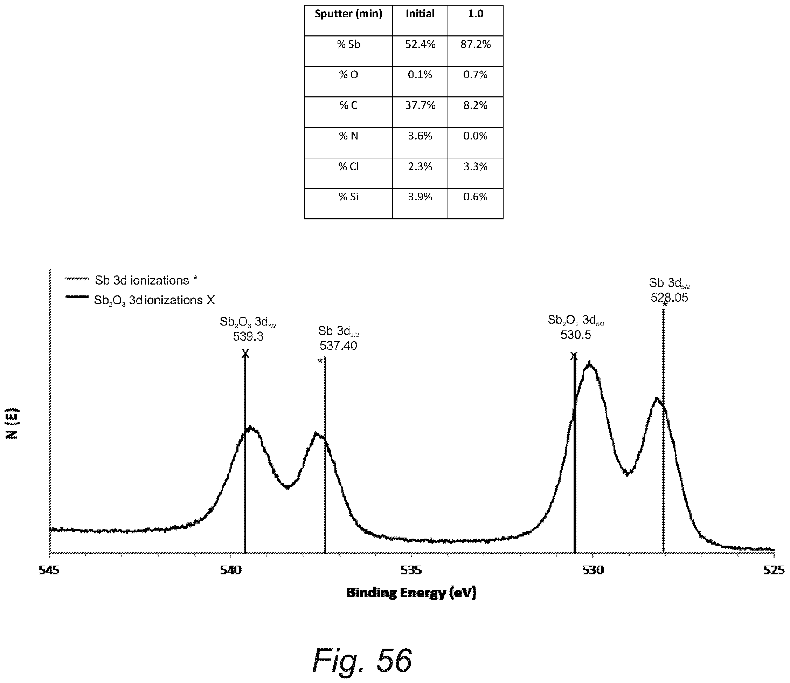

Figure 54D provides an SEM top-down view for an ALD film deposited on a palladium substrate from SbCl₃ and DHP at 180° C. Figures 55 and 56, respectively, show XPS survey scans and XPS multiplex scans for a 20 nm film deposited on a platinum substrate by reacting SbCl₃ and DHP at 180 C . The scans confirm the presence of an antimony-containing film.

### Synthesis of metal complexes:

The synthesis of the 1,4-di-tert-butyl-1,4-diazabutadiene ligand (dad^{tBu2}) was performed in accordance with a literature procedure (Kliegman, J. M.; Barnes, R. K. Tetrahedron 1970, 26, 2555-2560):

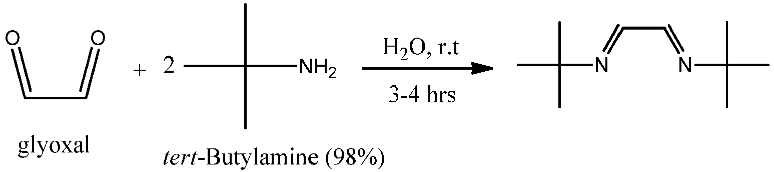

A previously reported procedure was used for the subsequent syntheses of Cr-, Mn-, Fe-, Co-, and Ni(dad^{tBu2})₂ compounds (Knisley, T. J.; Ariyasena, T. C.; Sajavaara, T.; Saly, M. J.; Winter, C. H. Chem. Mater. 2011, 23, 4417-4419). The syntheses of Mg- and Zn(dad^{tBu2})₂ followed an identical process. This general method was modified for the syntheses of Al- and Ti(dad^{tBu2})₂ compounds, whereby the reagents were cooled to -78 °C prior to cannulation of the ligand to the metal salt.

Crystal structures have been published for several M(dad^{tBu2})₂ complexes (M = Mg, Al, Cr, Fe, Co, Ni, Zn) (Cardiner, M. G.; Hanson, G. R.; Henderson, M. J.; Lee, F. C. Raston, C. L. Inorg. Chem. 1994, 33, 2456-2461; Geoffrey, F.; Cloke, N.; Dalby, C. I.; Henderson, M. J.; Hitchcock, P. B.; Kennard, C. H. L.; Lamb, R. N.; Raston, C. L. J. Chem. Soc., Chem. Commun. 1990, 1394-1396; Knisley, T. J.; Ariyasena, T. C.; Sajavaara, T.; Saly, M. J.; Winter, C. H. Chem. Mater. 2011, 23, 4417-4419). Ti(dad^{tBu2})₂ and Mn(dad^{tBu2})₂ have been reported in the literature, however, their structures have not been published (Tom Dieck, H.; Rieger, H. J.; Fendesak, G. Inorganica Chimica Acta 1990, 177, 191-197; Knisley, T. J.; Ariyasena, T. C. Sajavaara, T.; Saly, M. J.; Winter, C. H. Chem. Mater. 2011, 23, 4417-4419). Following the synthesis outlined in Scheme 3, a low-resolution structure of Ti(dad^{tBu2})₂ was obtained with crystals grown by sublimation of the crude product at 120 °C/0.05 Torr.

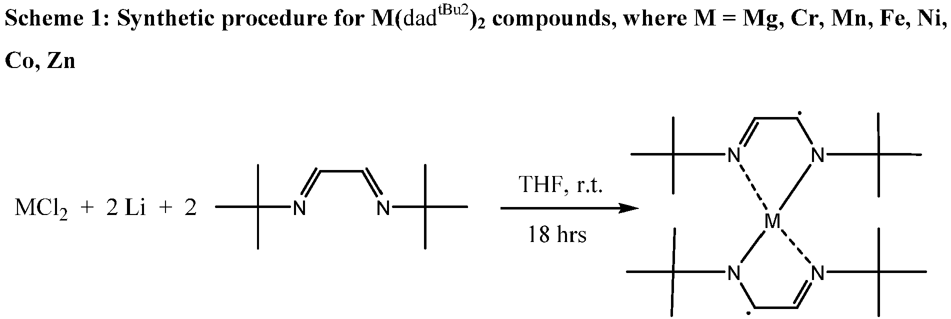

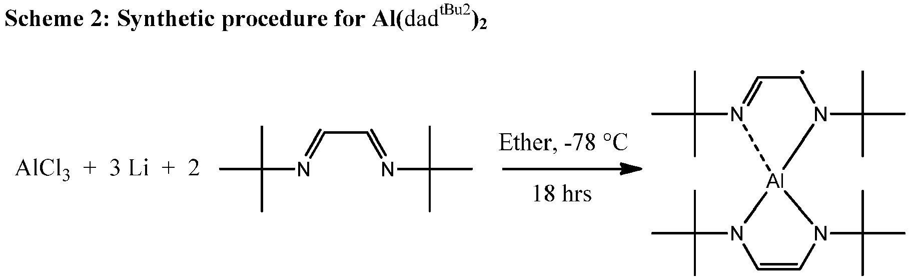

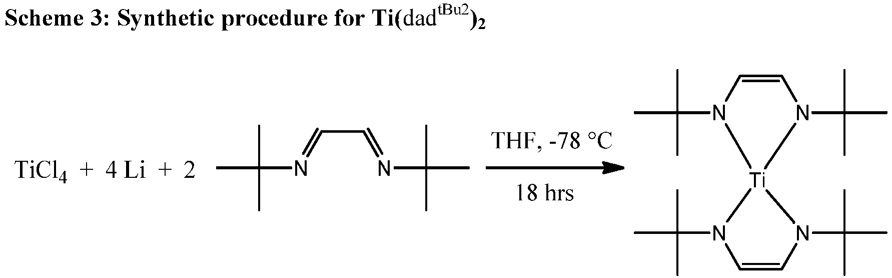

The procedure outlined in Scheme 2 afforded a mixture of Al(dad^{tBu2})Cl₂ and Al(dad^{tBu2})₂. These products were separable due to their difference in volatility. The novel Al(dad^{tBu2})Cl₂ compound sublimed at 105 °C/0.05 Torr, while the unexpected Al(dad^{tBu2})₂ product sublimed at 130 °C /0.05 Torr. Preparative sublimation studies on Al(dad^{tBu2})Cl₂ resulted in 88.9% recovered material, with 5.5% non-volatile residue. The melting point was determined as 157-158 °C.

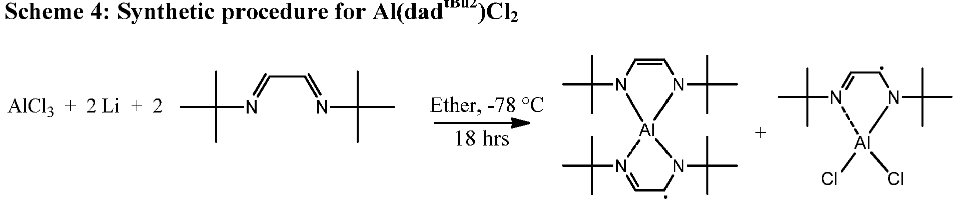

The general class of M(^{R2}DAD)Cl₂ (R = iPr, tBu, phenyl, methylphenyl, etc.) compounds may be especially useful for the deposition process described herein. Previously reported compounds of this family include 1,4-di(4-methylphenyl)1,4-diazabutadiene]ZnCl₂^{L} and Ti(dad^{tBu2})Cl₂(Tom Dieck, H.; Rieger, H. J.; Fendesak, G. Inorganica Chimica Acta 1990, 177, 191-197) however, the latter exists as a dimer in the solid state, where the titanium atoms are bridged by two chloro ligands. To date, no compounds of this general class have been used as precursors for film growth.

### ALD Deposition Experiments:

Co(dad^{tBu2})₂ + HCOOH

Metallic cobalt films were grown by ALD using a binary process of Co(dad^{tBu2})₂ + HCOOH. Each cycle consisted of a 6.0 s pulse of Co(dad^{tBu2})₂, a 5.0 s purge, a 0.2 s pulse of HCOOH, and a 5.0 s purge. The Co(dad^{tBu2})₂ was delivered by a solid state booster, maintained at a temperature of 140 °C, affording a source temperature of 137 ± 1 °C. The HCOOH was delivered by a bubbler maintained at 23 °C. Purified nitrogen was used as the carrier gas, with flow rates of 80 sccm for both precursors. The temperature of the reaction chamber spanned a range of 140-240 °C during the deposition experiments. All films were grown for 1000 cycles and allowed to cool to ambient temperature before exposure to air. Growth was achieved on a variety of metallic and insulating substrates, including Si(100), SiO₂, Cu, Pt, Pd, and Ru.

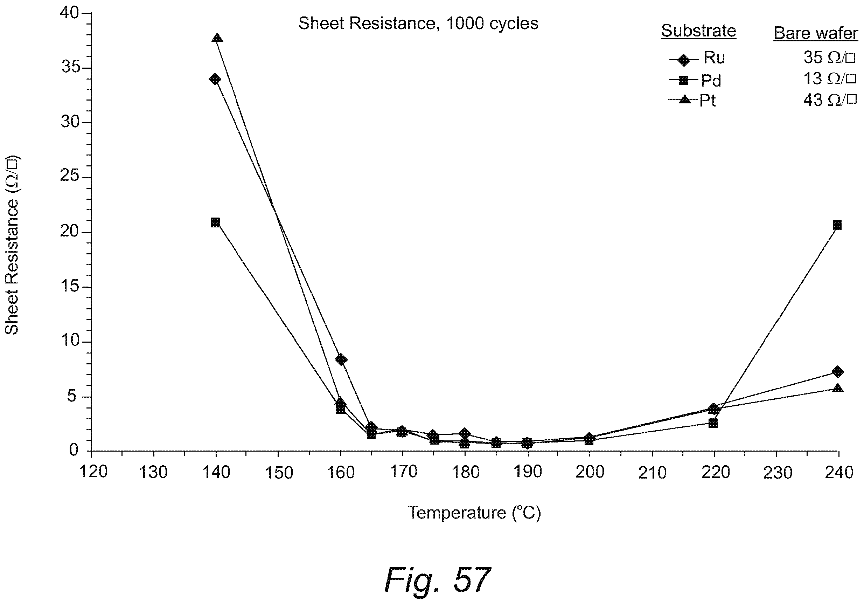

Cobalt films deposited within the 165-200 °C window had extremely low sheet resistivities of 1-2 Ω/□ when grown on Ru, Pt, and Pd substrates (Figure 57). The bulk resistivities of the cobalt films grown on Ru within the 165-225 °C temperature range are 13-19 µΩ cm; these values approach that of bulk cobalt metal (6.24 µΩ cm at 20 °C).

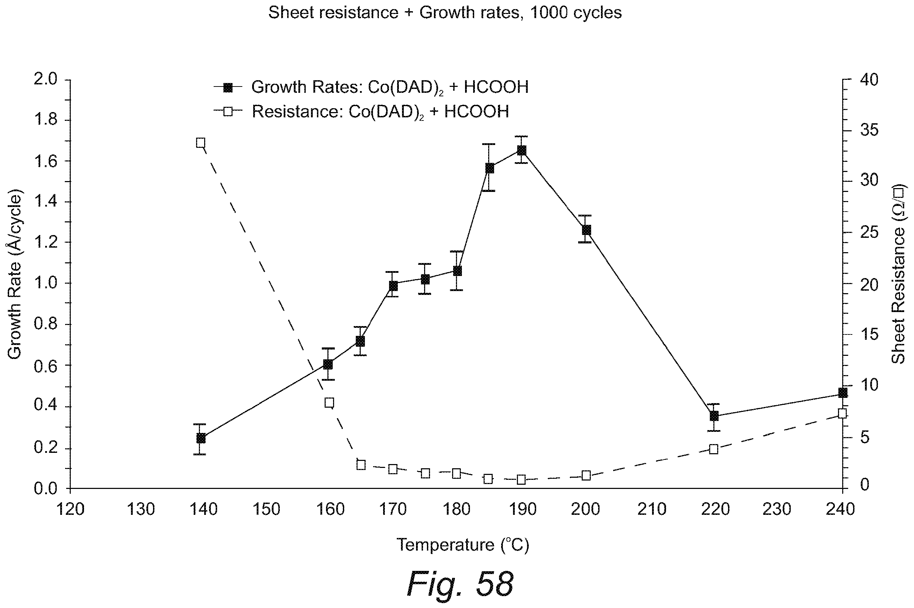

Films deposited on Ru substrates at 165 °C, 180 °C, and 200 °C had respective growth rates of 1.15 Å/cycle, 1.06 Å/cycle, 1.27 Å/cycle. A region of constant growth was observed from 170-180 °C (Figure 58).

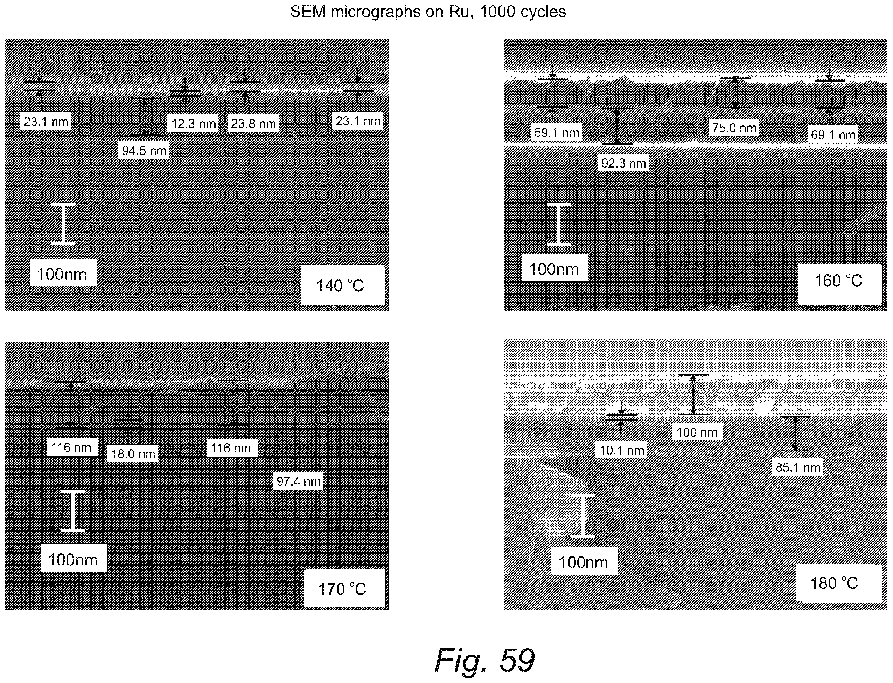

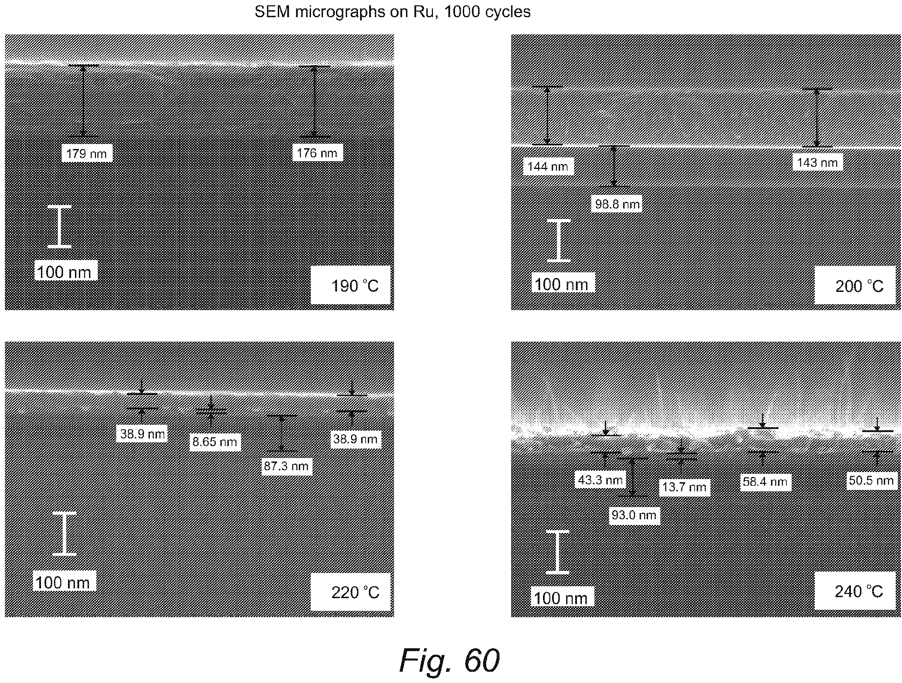

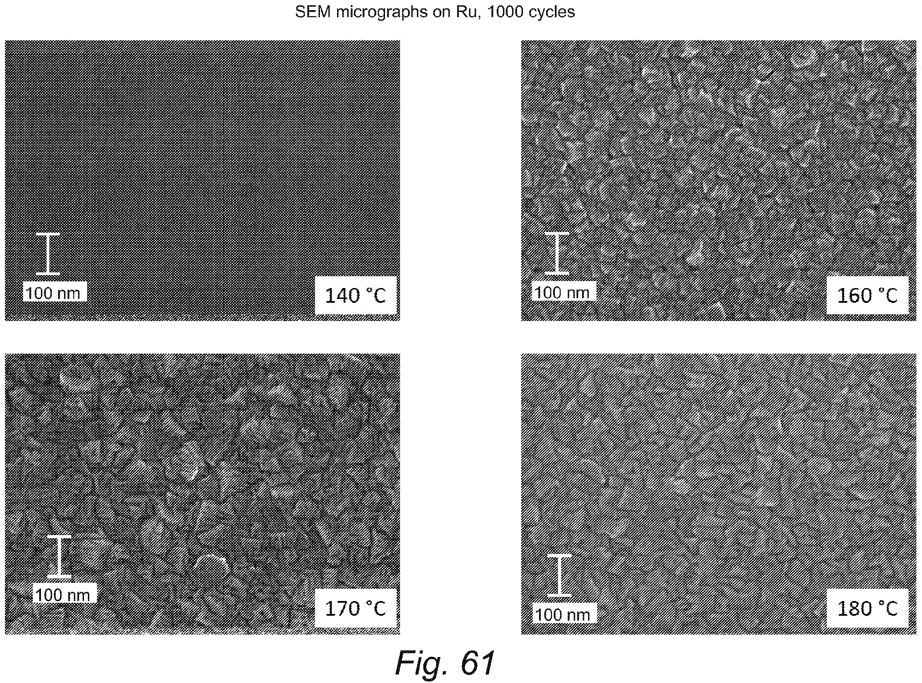

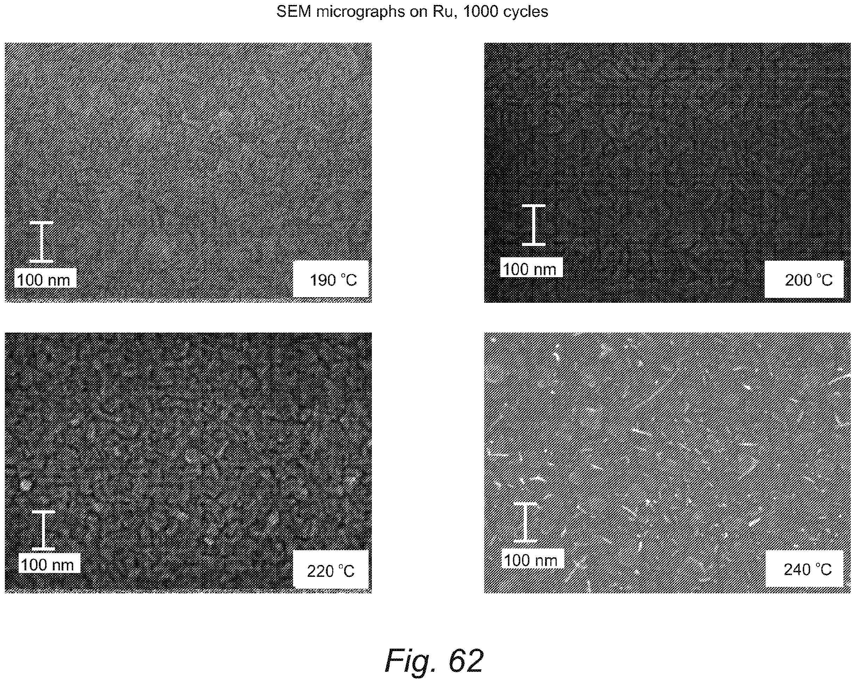

Cross-sectional SEM micrographs show uniform, granular films within the 160-220 °C range (Figures 59-60). Top-down SEM micrographs of these films show a granular morphology suggestive of metallic films (Figures 61-62). Analogous processes have been used for the deposition of elemental Ni films and films containing Cr, Fe, and Mn.

## Claims

1. A method of forming a layer on a substrate, the method comprising a deposition cycle including:
a) contacting a substrate with a vapor of a first compound to form a first modified surface, the first compound having an atom in an oxidized state to form said first modified surface, said atom being selected from the group consisting of Cu, Ni, Cr, Mn, Fe, Co;
b) contacting the first modified surface with an acid for a second predetermined pulse time to form a second modified surface; and
c) contacting the second modified surface with a reducing agent for a third predetermined pulse time to reduce the atom to a zero oxidation state and to form a layer on the substrate, the reducing agent being 1,4-bis(trimethylsilyl)-1,4-dihydropyrazine.

2. The method of claim 1, wherein the atom is in a positive oxidation state of 1, 2, 3, 4, 5, or 6.

3. The method according to claim 1, wherein said first compound is selected from bis(dimethylamino-2-propoxy) copper (II) (Cu(dmap)₂), bis(dimethylamino-2-propoxy) nickel (II) (Ni(dmap)₂, bis(1,4-di-tert-butyldiazene) chromium(II) (Cr(dad^{tBu2})₂), bis(1,4-di-tert-butyldiazene) manganese (II) (Mn(dad^{tBu2})₂), bis(1,4-di-tert-butyldiazene) iron(II) (Fe(dad^{tBu2})₂), bis(1,4-di-tert-butyldiazene) cobalt(II) (Co(dad^{tBu2})₂) and bis(1,4-di-tert-butyldiazene) nickel(II) (Ni(dad^{tBu2})₂).

4. The method of claim 1, wherein the substrate is additionally contacted with the vapor of the first compound having an atom in an oxidized state, the acid, and the vapor of a reducing agent during a plurality of additional deposition cycles.

5. The method according to claim 1, wherein said substrate is selected from SiH and Co when said first compound is Cu(dmap)₂, Si when said first compound is Ni(Dmap)₂, Ru when said first compound is Ni(Dmap)₂ or Ni(dad^{tBu2})₂, Pd when said first compound is Ni(Dmap)₂, Cu when said first compound is Ni(dad^{tBu2})₂, Ru or SiO₂ when said first compound is Cr(dad^{tBu2})₂, Ru or SiO₂ when said first compound is Mn(dad^{tBu2})₂, SiO₂ when said first compound is Fe(dad^{tBu2})₂, Ru or SiO₂ when said first compound is Co(dad^{tBu2})₂

6. The method according to claim 1, wherein said acid is formic acid.

## Patentansprüche

1. Verfahren zum Bilden einer Schicht auf einem Substrat, wobei das Verfahren einen Abscheidungszyklus mit folgenden Schritten umfasst:
a) Inkontaktbringen eines Substrats mit einem Dampf einer ersten Verbindung, um eine erste modifizierte Oberfläche zu bilden, wobei die erste Verbindung ein Atom in einem oxidierten Zustand aufweist, um die erste modifizierte Oberfläche zu bilden, wobei das Atom ausgewählt ist aus der Gruppe bestehend aus Cu, Ni, Cr, Mn, Fe, Co;
b) Inkontaktbringen der ersten modifizierten Oberfläche mit einer Säure für eine zweite vorgegebene Impulszeit, um eine zweite modifizierte Oberfläche zu bilden; und
c) Inkontaktbringen der zweiten modifizierten Oberfläche mit einem Reduktionsmittel für eine dritte vorgegebene Impulszeit, um das Atom auf einen Nulloxidationszustand zu reduzieren und eine Schicht auf dem Substrat zu bilden, wobei das Reduktionsmittel 1,4-Bis(trimethylsilyl)-1,4-dihydropyrazin ist.

2. Verfahren nach Anspruch 1, bei dem das Atom in einem positiven Oxidationszustand von 1, 2, 3, 4, 5 oder 6 vorliegt.

3. Verfahren nach Anspruch 1, bei dem die erste Verbindung ausgewählt ist aus Bis(dimethylamino-2-propoxy)-Kupfer(II) (Cu(dmap)₂), Bis(dimethylamino-2-propoxy)-Nickel(II) (Ni(dmap)₂, Bis(1,4-di-tert-butyldiazen)-Chrom(II) (Cr(dad^{tBu2})₂), Bis(1,4-di-tert-butyldiazen)-Mangan(II) (Mn(dad^{tBu2})₂), Bis(1,4-di-tert-butyldiazen)-Eisen(II) (Fe(dad^{tBu2})²), Bis(1,4-di-tert-butyldiazen)-Kobalt(II) (Co(dad^{tBu2})₂) und Bis(1,4-di-tert-butyldiazen)-Nickel(II) (Ni(dadtBu2)2).

4. Verfahren nach Anspruch 1, bei dem das Substrat zusätzlich während einer Mehrzahl von zusätzlichen Abscheidungszyklen mit dem Dampf der ersten Verbindung, die ein Atom in einem oxidierten Zustand aufweist, der Säure und dem Dampf eines Reduktionsmittels in Kontakt gebracht wird.

5. Verfahren nach Anspruch 1, bei dem das Substrat ausgewählt ist aus SiH und Co, wenn die erste Verbindung Cu(dmap)₂ ist, Si ist, wenn die erste Verbindung Ni(Dmap)₂ ist, Ru ist, wenn die erste Verbindung Ni(Dmap)₂ oder Ni(dad^{tBu2})₂ ist, Pd ist, wenn die erste Verbindung Ni(Dmap)₂ ist, Cu, wenn die erste Verbindung Ni(dad^{tBu2})₂ ist, Ru oder SiO₂ ist, wenn die erste Verbindung Cr(dad^{tBu2})₂ ist, Ru oder SiO₂ ist, wenn die erste Verbindung Mn(dad^{tBu2})₂ ist, SiO₂ ist, wenn die erste Verbindung Fe(dad^{tBu2})₂ ist, Ru oder SiO₂ ist, wenn die erste Verbindung Co(dad^{tBu2})₂ ist.

6. Verfahren nach Anspruch 1, bei dem die Säure Ameisensäure ist.

## Revendications

1. Procédé de formation d'une couche sur un substrat, le procédé comprenant un cycle de dépôt prévoyant de :
a) mettre en contact un substrat avec une vapeur d'un premier composé pour former une première surface modifiée, le premier composé ayant un atome dans un état oxydé afin de former ladite première surface modifiée, ledit atome étant sélectionné parmi le groupe constitué de Cu, Ni, Cr, Mn, Fe et Co ;
b) mettre en contact la première surface modifiée avec un acide pour une deuxième durée d'impulsion prédéterminée afin de former une deuxième surface modifiée ; et
c) mettre en contact la seconde surface modifiée avec un agent réducteur pour une troisième durée d'impulsion prédéterminée afin de réduire l'atome à un état d'oxydation nul et de former une couche sur le substrat, l'agent réducteur étant 1,4-bis (triméthylsilyle)-1,4-dihydropyrazine.

2. Procédé selon la revendication 1, dans lequel l'atome est dans un état d'oxydation positif de 1, 2, 3, 4, 5, ou 6.

3. Procédé selon la revendication 1, dans lequel ledit premier composé est sélectionné parmi les composés suivants : bis(diméthylamino-2-propoxy) cuivre (II) (Cu(dmap)₂), bis(diméthylamino-2-propoxy) nickel (II) (Ni(dmap)₂, bis(1,4-di-tert-butyldiazène) chrome (II) (Cr(dad^{tBu2})₂), bis(1,4-di-tert-butyldiazène) manganèse (II) (Mn(dad^{tBu2})₂), bis(1,4-di-tert-butyldiazène) fer (II) (Fe(dad^{tBu2})₂), bis(1,4-di-tert-butyldiazène) cobalt (II) (Co(dad^{tBu2})₂) et bis(1,4-di-tert-butyldiazène) nickel (II) (Ni(dad^{tBu2})₂).

4. Procédé selon la revendication 1, dans lequel le substrat est en outre mis en contact avec la vapeur du premier composé ayant un atome dans un état oxydé, avec l'acide et avec la vapeur d'un agent réducteur durant une série de cycles de dépôt supplémentaires.

5. Procédé selon la revendication 1, dans lequel ledit substrat est sélectionné parmi du SiH et du Co lorsque ledit premier composé est du Cu(dmap)₂, du Si lorsque ledit premier composé est du Ni(Dmap)₂, du Ru lorsque ledit premier composé est du Ni(Dmap)₂ ou du Ni(dad^{tBu2})₂, du Pd lorsque ledit premier composé est du Ni(Dmap)₂, du Cu lorsque ledit premier composé est du Ni(dad^{tBu2})₂, du Ru ou du SiO₂ lorsque ledit premier composé est du Cr(dad^{tBu2})₂, du Ru ou du SiO₂ lorsque ledit premier composé est du Mn(dad^{tBu2})₂, du SiO₂ lorsque ledit premier composé est du Fe(dad^{tBu2})₂, du Ru ou du SiO₂ lorsque ledit premier composé est du Co(dad^{Bu2})₂.

6. Procédé selon la revendication 1, dans lequel ledit acide est de l'acide formique.
